(19) Europäisches Patentamt
European Patent Office
Office européen des brevets

(11) EP 4 180 500 A1

(12) EUROPEAN PATENT APPLICATION
published in accordance with Art. 153(4) EPC

(43) Date of publication:
**17.05.2023 Bulletin 2023/20**

(21) Application number: **21837328.0**

(22) Date of filing: **06.07.2021**

(51) International Patent Classification (IPC):
***C09K 11/06*** (2006.01) ***H01L 51/50*** (2006.01)

(52) Cooperative Patent Classification (CPC):
**C09K 11/06; H10K 50/00**

(86) International application number:
**PCT/JP2021/025469**

(87) International publication number:
**WO 2022/009883 (13.01.2022 Gazette 2022/02)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **08.07.2020 JP 2020118001**

(71) Applicants:
- **NIPPON STEEL Chemical & Material Co., Ltd.**
  **Tokyo 103-0027 (JP)**
- **Kyushu University, National University Corporation**
  **Nishi-ku**
  **Fukuoka-shi**
  **Fukuoka 819-0395 (JP)**

(72) Inventors:
- **TADA, Masashi**
  **Tokyo 103-0027 (JP)**
- **SAGARA, Yuta**
  **Tokyo 103-0027 (JP)**
- **KAWADA, Atsushi**
  **Tokyo 103-0027 (JP)**
- **YASUDA, Takuma**
  **Fukuoka-shi, Fukuoka 819-0395 (JP)**
- **PARK, In Seob**
  **Fukuoka-shi, Fukuoka 819-0395 (JP)**
- **KIM, Jong Uk**
  **Fukuoka-shi, Fukuoka 819-0395 (JP)**
- **SHIKITA, So**
  **Fukuoka-shi, Fukuoka 819-0395 (JP)**

(74) Representative: **Vossius & Partner**
**Patentanwälte Rechtsanwälte mbB**
**Siebertstraße 3**
**81675 München (DE)**

# (54) HEAT-ACTIVATED DELAYED FLUORESCENCE MATERIAL AND ORGANIC ELECTROLUMINESCENT ELEMENT

(57) Provided is a thermally activated delayed fluorescence organic EL device having high emission efficiency and a long lifetime. An organic EL device comprising light emitting layers between an anode and a cathode opposite to each other; wherein at least one of the light emitting layers contains, as a thermally activated delayed fluorescence material, a compound in which a boron-containing electron acceptor backbone is linked with an electron donor backbone having a specific fused ring structure; and the compound is represented by the following general formula (1) where $X^1$ is O or S.

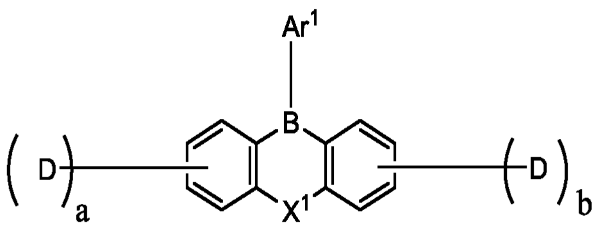
(1)

EP 4 180 500 A1

[ Fig. 1 ]

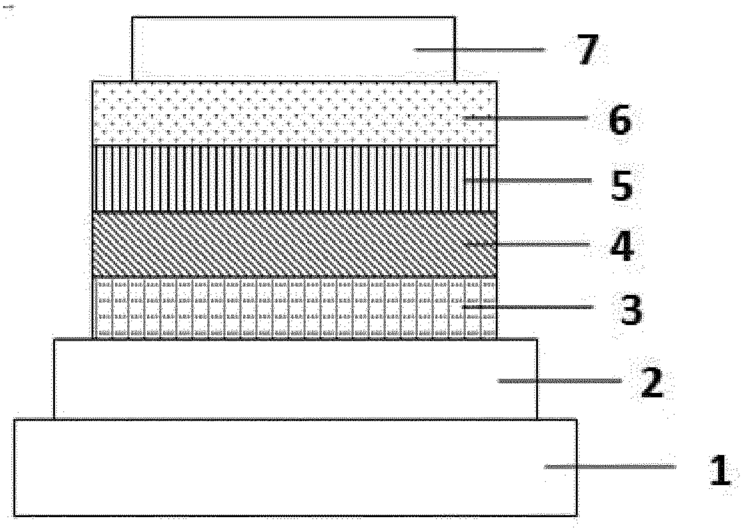

## Description

Technical Field

The present invention relates to a thermally activated delayed fluorescence material and an organic electroluminescent element or device (also referred to as an organic EL element or device) including the thermally activated delayed fluorescence material as a light emitting layer.

When a voltage is applied to an organic EL device, holes and electrons are injected from the anode and the cathode, respectively, into the light emitting layer. Then, the injected holes and electrons are recombined in the light emitting layer to thereby generate excitons. At this time, according to the electron spin statistics theory, singlet excitons and triplet excitons are generated at a ratio of 1:3. In the fluorescent organic EL device that uses emission caused by singlet excitons, the limit of the internal quantum efficiency is said to be 25%. On the other hand, it has been known that, in the phosphorescent organic EL device that uses emission caused by triplet excitons, the internal quantum efficiency can be enhanced up to 100% when intersystem crossing efficiently occurs from singlet excitons.

A technology for extending the lifetime of a phosphorescent organic EL device has advanced in recent years, and the device is being applied to a display of a mobile phone and others. Regarding a blue organic EL device, however, a practical phosphorescent organic EL device has not been developed, and thus the development of a blue organic EL device having high efficiency and a long lifetime is desired.

Further, a highly efficient delayed fluorescence organic EL device utilizing delayed fluorescence has been developed, in recent years. For example, Patent Literature 1 discloses an organic EL device utilizing the Triplet-Triplet Fusion (TTF) mechanism, which is one of the mechanisms of delayed fluorescence. The TTF mechanism utilizes a phenomenon in which a singlet exciton is generated by the collision of two triplet excitons, and it is believed that the internal quantum efficiency can be enhanced up to 40%, in theory. However, its efficiency is low as compared with the efficiency of the phosphorescent organic EL device, and thus further improvement in efficiency is desired.

On the other hand, Patent Literature 2 discloses an organic EL device utilizing the Thermally Activated Delayed Fluorescence (TADF) mechanism. The TADF mechanism utilizes a phenomenon in which reverse intersystem crossing occurs from the triplet exciton to the singlet exciton in a material having a small energy difference between the singlet level and the triplet level, and it is believed that the internal quantum efficiency can be enhanced up to 100%, in theory. Specifically, Patent Literature 2 discloses an indolocarbazole compound shown below as a thermally activated delayed fluorescence material.

[C1]

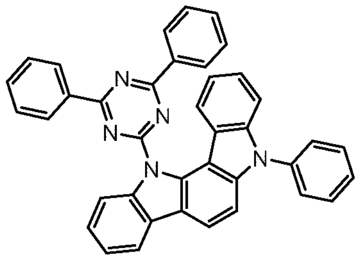

Patent Literature 3 discloses an organic electroluminescent device in which an indolocarbazole compound shown below is used in the delayed fluorescence light emitting layer.

[C2]

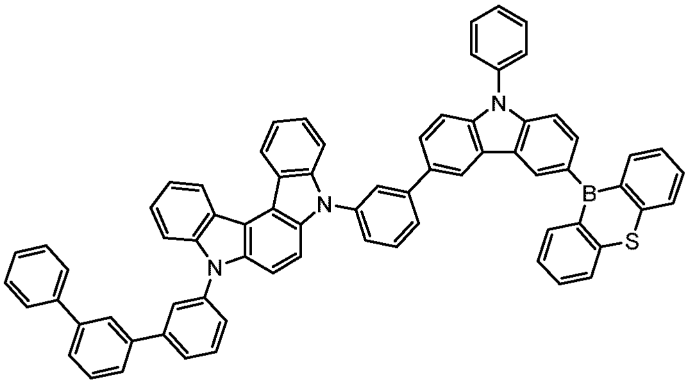

Patent Literature 4 discloses a thermally activated delayed fluorescence material as shown below.

[C3]

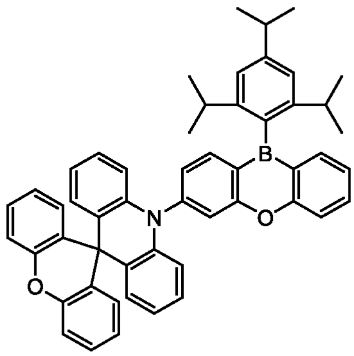

However, further improvement in lifetime characteristics is needed for the thermally activated delayed fluorescence organic EL device as in the case of the phosphorescent device. In other words, a delayed fluorescence organic EL device in which such a thermally activated delayed fluorescence emitting material is utilized is characterized by high emission efficiency, but further improvement is desired.

Citation List

Patent Literature

Patent Literature 1: WO2010/134350
Patent Literature 2: WO2011/070963
Patent Literature 3: WO2014/050904
Patent Literature 4: WO2015/072537

Summary of Invention

Technical Problem

In view of applying an organic EL device to a display device such as a flat panel display and a light source, it is necessary to improve the emission efficiency of the device and sufficiently ensure the stability of the device at the time of driving, at the same time. The present invention has been made under such circumstances, and an object thereof is to provide a thermally activated delayed fluorescence material that can be used to obtain a practically useful organic

EL device having high emission efficiency and high driving stability, and an organic EL device including the thermally activated delayed fluorescence material.

Solution to Problem

Specifically, the present invention is a thermally activated delayed material represented by the following general formula (1) and also an organic EL device comprising one or more light emitting layers between an anode and a cathode opposite to each other, wherein at least one of the light emitting layers contains the thermally activated delayed fluorescence material.

[C4]

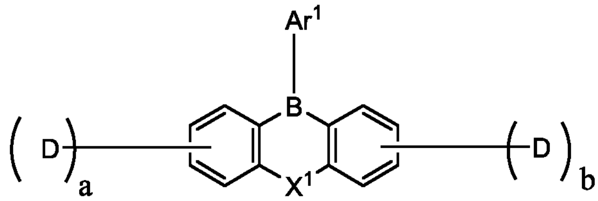
(1)

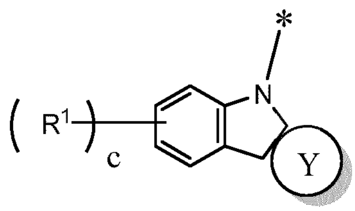
(1a)

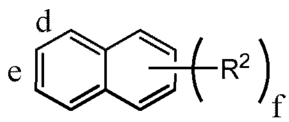
(1a-1)

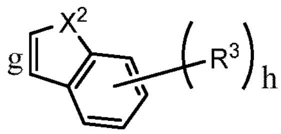
(1a-2)

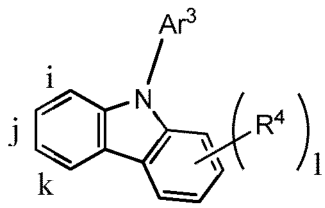
(1a-3)

In the formula, $X^1$ represents O or S. D is independently a nitrogen-containing heterocycle represented by formula (1a), * in the formula (1a) represents a bonding site to a ring in the general formula (1) is bonded, and the ring Y is any of formulas (1a-1), (1a-2), and (1a-3).

When the ring Y is the formula (1a-1), the ring Y is fused at either position d or e. When the ring Y is the formula (1a-2), the ring Y is fused at a position g, and $X^2$ represents O, S, or N-$Ar^2$. When the ring Y is the formula (1a-3), the ring Y is fused at any of the positions i, j, and k. $Ar^1$ to $Ar^3$ each represent a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group formed by linking 2 to 5 aromatic rings thereof. $R^1$ to $R^4$ each represent deuterium, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms, a and b each represent the number of substitutions and integer of 0 or 1, provided that a case where a and b are both 0 is excluded. c, f, h, and 1 each represent the number of substitutions and an integer of 0 to 4.

In the formula (1a), the Y is preferably represented by the formula (1a-2) or (1a-3).

$X^1$ in the general formula (1) is preferably S.

The thermally activated delayed fluorescence emission material represented by the general formula (1) may have a difference between singlet excited energy (S1) and triplet excited energy (T1) of less than 0.20 eV, and preferably less than 0.10 eV.

Advantageous Effect of Invention

An organic EL device having high emission efficiency and a long lifetime can be provided by incorporating the thermally activated delayed fluorescence material of the present invention into the light emitting layer.

Brief Description of Drawing

[Figure 1] Figure 1 shows a schematic cross-sectional view of a structure example of the organic EL device used in the present invention.

Description of Embodiments

The organic EL device of the present invention has one or more light emitting layers between an anode and a cathode opposite to each other, and at least one of the light emitting layers contains a thermally activated delayed fluorescence material (referred to as a TADF material) represented by the general formula (1). The organic EL device has a plurality of layers between an anode and a cathode opposite to each other, at least one of the plurality of layers is a light emitting layer, and the light emitting layer may contain a host material, as necessary.

Further, the organic EL device can contain a light emitting dopant other than the thermally activated delayed fluorescence material represented by the general formula (1).

The general formula (1) will be described below.

First, $X^1$ represents O or S. $X^1$ preferably represents S.

D is independently a nitrogen-containing heterocycle represented by the formula (1a), and the ring Y in the formula (1a) is any of the formulas (1a-1), (1a-2), and (1a-3), preferably the formula (1a-2) or (1a-3), and more preferably the formula (1a-3). When the ring Y is the formula (1a-1), the ring Y is fused at either position d or e. When the ring Y is the formula (1a-2), the ring Y is fused at a position g. $X^2$ represents O, S, or N-$Ar^2$, and preferably represents N-$Ar^2$. When the ring Y is the formula (1a-3), the ring Y is fused at any of positions i, j, and k, and preferably fused at a position i. a and b each represent the number of substitutions and integer of 0 or 1, provided that a case where a and b are both 0 is excluded.

$Ar^1$ to $Ar^3$ each independently represent a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group formed by linking 2 to 5 aromatic rings thereof. Preferably, $Ar^1$ to $Ar^3$ each represent an unsubstituted aromatic hydrocarbon group having 6 to 15 carbon atoms, a substituted or unsubstituted aromatic heterocyclic group having 3 to 15 carbon atoms, or a substituted or unsubstituted linked aromatic group formed by linking 2 to 4 aromatic rings thereof. More preferably, $Ar^1$ to $Ar^3$ each represent an unsubstituted aromatic hydrocarbon group having 6 to 12 carbon atoms, a substituted or unsubstituted aromatic heterocyclic group having 3 to 12 carbon atoms, or a substituted or unsubstituted linked aromatic group formed by linking 2 to 3 aromatic rings thereof.

Specific examples of the unsubstituted $Ar^1$ to $Ar^3$ include a group produced by removing one hydrogen atom from benzene, naphthalene, acenaphthene, acenaphthylene, azulene, anthracene, chrysene, pyrene, phenanthrene, triphenylene, fluorene, benzo[a]anthracene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, carbazole, and a compound formed by linking 2 to 5 of these compounds. Preferred examples thereof include a group produced by removing one hydrogen atom from benzene, naphthalene, acenaphthene, acenaphthylene, azulene, anthracene, phenanthrene, fluorene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, carbazole, and a compound formed by linking 2 to 4 of these compounds. More preferred examples thereof include a group produced by removing one hydrogen atom from benzene, naphthalene, acenaphthene, acenaphthylene, azulene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, carbazole, and a compound formed by linking 2 to 3 of these compounds.

Each of these aromatic hydrocarbon groups, aromatic heterocyclic groups, and linked aromatic groups may have a substituent. When these groups have a substituent, the substituent is a cyano group, an aliphatic hydrocarbon group having 1 to 10 carbon atoms, a diarylamino group having 12 to 44 carbon atoms, an alkoxy group having 1 to 10 carbon atoms, an aryloxy group having 6 to 18 carbon atoms, an alkylthio group having 1 to 10 carbon atoms, or an arylthio group having 6 to 18 carbon atoms. The number of substituents is 0 to 5, and preferably 0 to 2. When each of the aromatic hydrocarbon groups and aromatic heterocyclic groups has a substituent, the number of carbon atoms of the substituent is not included in the calculation of the number of carbon atoms. However, it is preferred that the total number of carbon atoms including the number of carbon atoms of the substituent satisfy the above range.

Specific examples of the above substituent include cyano, methyl, ethyl, propyl, butyl, pentyl, hexyl, heptyl, octyl, nonyl, decyl, diphenylamino, naphthylphenylamino, dinaphthylamino, dianthranilamino, diphenanthrenylamino, dipyrenylamino, methoxy, ethoxy, phenol, diphenyloxy, methylthio, ethylthio, thiophenol, and diphenylthio. Preferred examples thereof include cyano, methyl, ethyl, propyl, butyl, pentyl, hexyl, heptyl, octyl, diphenylamino, naphthylphenylamino, dinaphthylamino, phenol, and thiophenol.

$R^1$ to $R^4$ each independently represent deuterium, an aliphatic hydrocarbon group having 1 to 10 carbon atoms, a substituted or unsubstituted aromatic hydrocarbon group having 6 to 18 carbon atoms, or an aromatic heterocyclic group having 3 to 17 carbon atoms. Among them, $R^1$ to $R^4$ each preferably represent deuterium, an aliphatic hydrocarbon group having 1 to 8 carbon atoms, a substituted or unsubstituted aromatic hydrocarbon group having 6 to 15 carbon atoms, or an aromatic heterocyclic group having 3 to 15 carbon atoms. More preferably, $R^1$ to $R^4$ each represent an aliphatic hydrocarbon group having 1 to 6 carbon atoms, a substituted or unsubstituted aromatic hydrocarbon group having 6 to 12 carbon atoms, aromatic heterocyclic group having 3 to 12 carbon atoms, c, f, h, and 1 each represent an integer of 0 to 4.

When $R^1$ to $R^4$ are an aliphatic hydrocarbon group having 1 to 10 carbon atoms, specific examples of $R^1$ to $R^4$ include methyl, ethyl, propyl, butyl, pentyl, hexyl, heptyl, octyl, and nonyl. Preferred examples thereof include methyl, ethyl, propyl, butyl, pentyl, hexyl, heptyl, and octyl.

When $R^1$ to $R^4$ are an unsubstituted aromatic hydrocarbon group having 6 to 18 carbon atoms or an unsubstituted aromatic heterocyclic group having 3 to 17 carbon atoms, specific examples of $R^1$ to $R^4$ include a group produced by removing one hydrogen atom from benzene, naphthalene, acenaphthene, acenaphthylene, azulene, anthracene, chrysene, pyrene, phenanthrene, triphenylene, fluorene, benzo[a]anthracene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, and carbazole. Preferred examples thereof include a group produced by removing one hydrogen atom from benzene, naphthalene, acenaphthene, acenaphthylene, azulene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, and carbazole. More preferred examples thereof include a group produced by removing one hydrogen atom from benzene, naphthalene, azulene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, and carbazole.

Each of these aromatic hydrocarbon groups and aromatic heterocyclic groups may have a substituent. When these groups have a substituent, the substituent is a cyano group, an aliphatic hydrocarbon group having 1 to 10 carbon atoms, or a diarylamino group having 12 to 44 carbon atoms. The number of substituents is 0 to 5, and preferably 0 to 2. When each of the aromatic hydrocarbon groups and aromatic heterocyclic groups has a substituent, the number of carbon atoms of the substituent is not included in the calculation of the number of carbon atoms. However, it is preferred that the total number of carbon atoms including the number of carbon atoms of the substituent satisfy the above range.

Specific examples of the above substituent include cyano, methyl, ethyl, propyl, butyl, pentyl, hexyl, heptyl, octyl, nonyl, decyl, diphenylamino, naphthylphenylamino, dinaphthylamino, dianthranilamino, and diphenanthrenylamino, dipyrenylamino. Preferred examples thereof include cyano, methyl, ethyl, propyl, butyl, pentyl, hexyl, heptyl, octyl, diphenylamino, naphthylphenylamino, and dinaphthylamino.

Specific examples of the thermally activated delayed fluorescence materials represented by the general formula (1) are shown below, but the materials are not limited to these exemplified compounds.

[C5]

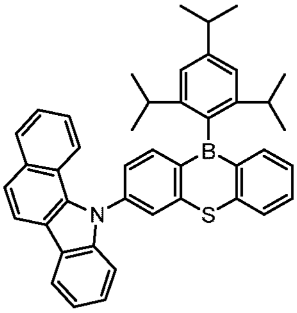

1-1

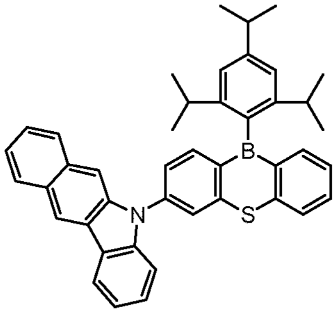

1-2

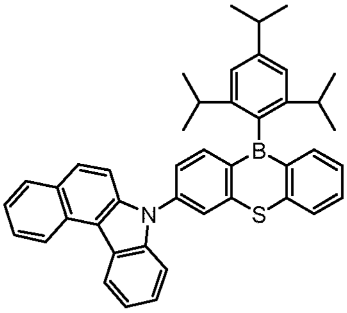

1-3

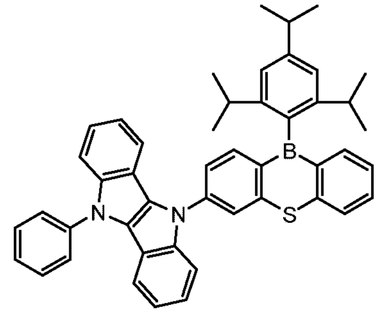

1-4

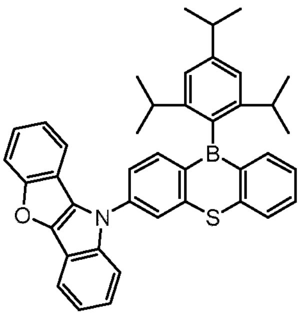

1-5

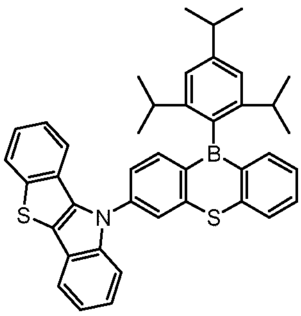

1-6

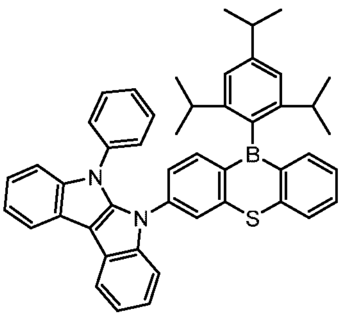

1-7

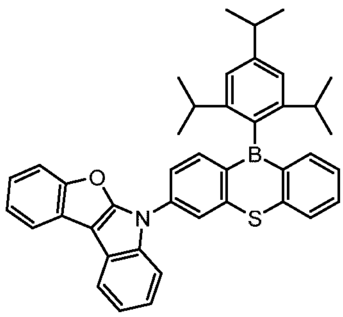

1-8

[C6]

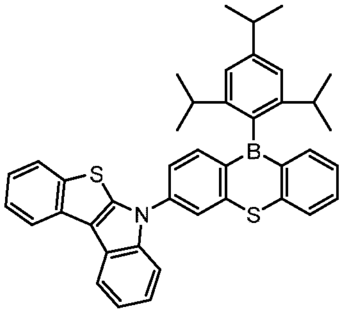

1-9

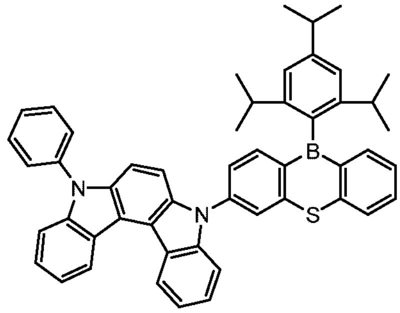

1-10

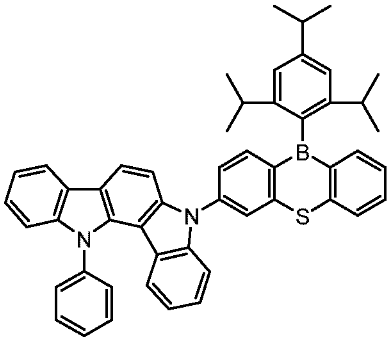

1-11

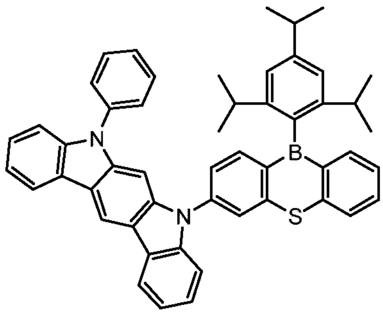

1-12

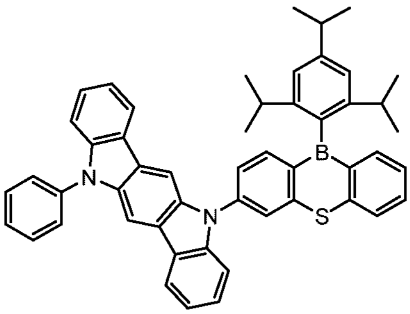

1-13

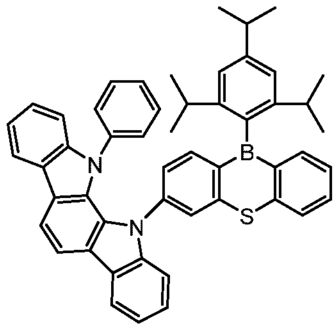

1-14

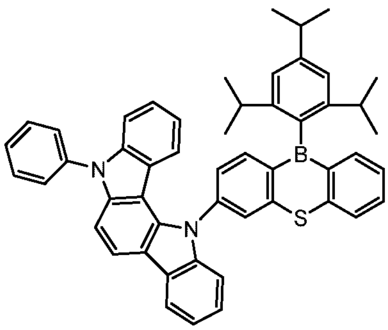

1-15

[C7]

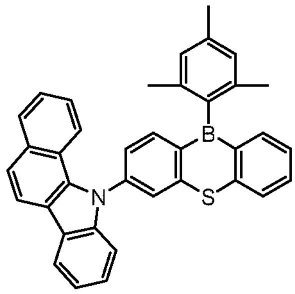

1-16

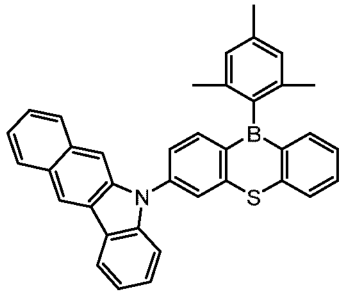

1-17

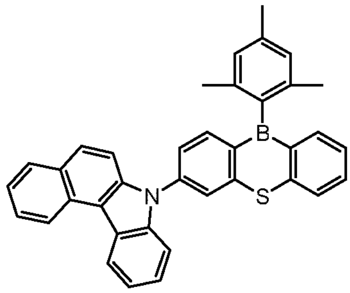

1-18

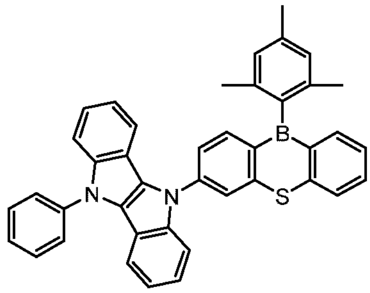

1-19

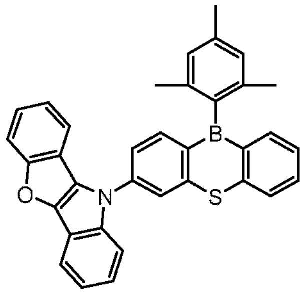

1-20

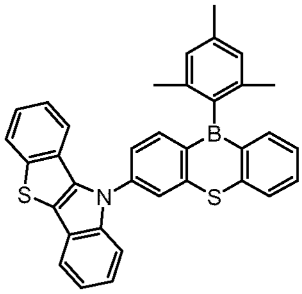

1-21

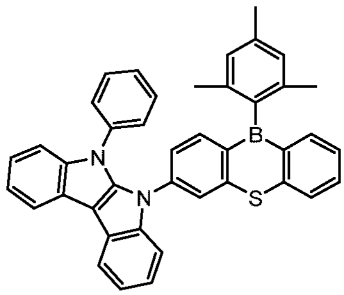

1-22

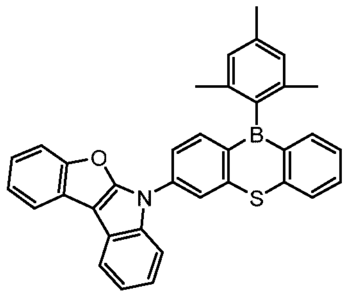

1-23

[C8]

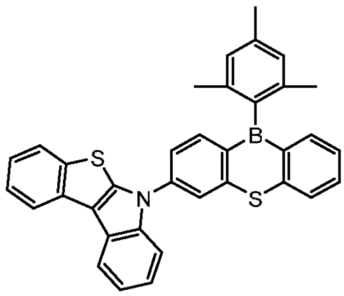

1-24

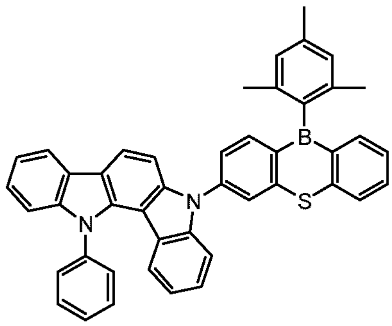

1-25

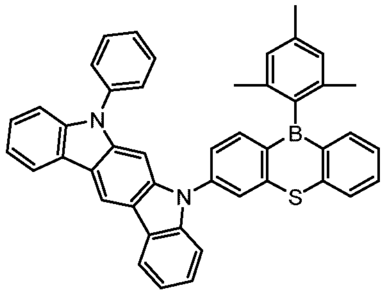

1-26

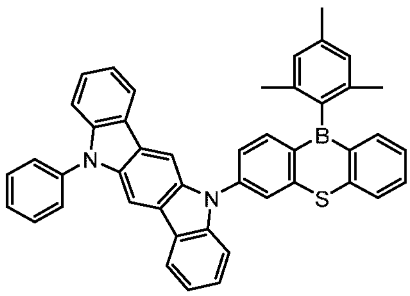

1-27

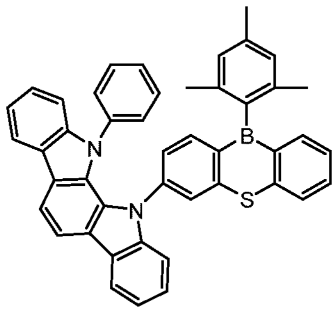

1-28

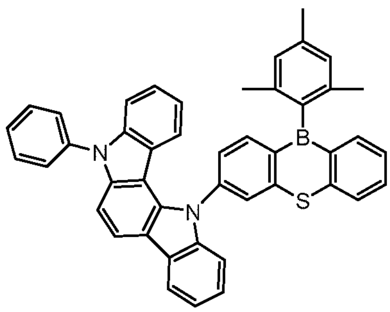

1-29

[C9]

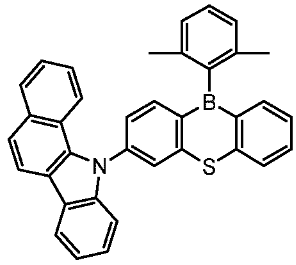

1-30

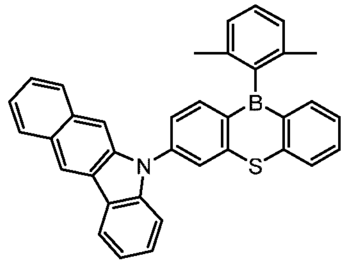

1-31

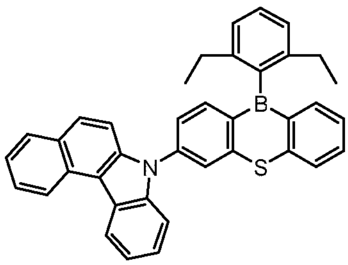

1-32

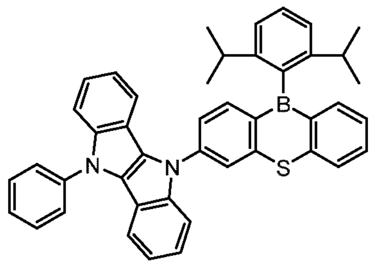

1-33

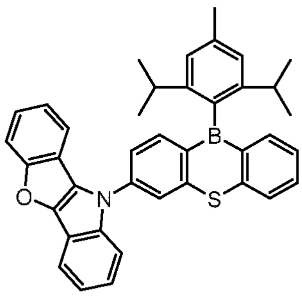

1-34

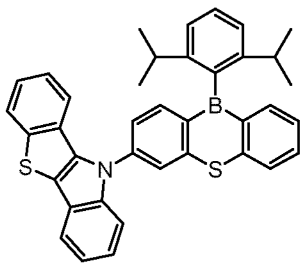

1-35

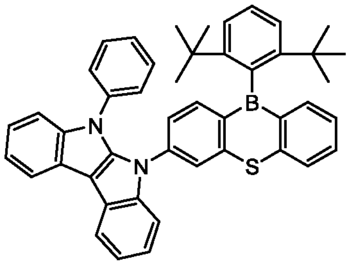

1-36

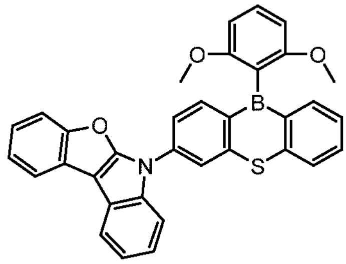

1-37

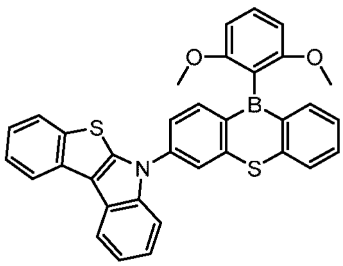

1-38

[C10]

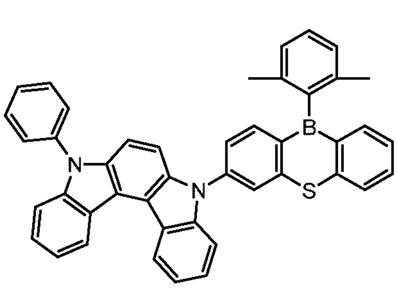

1-39

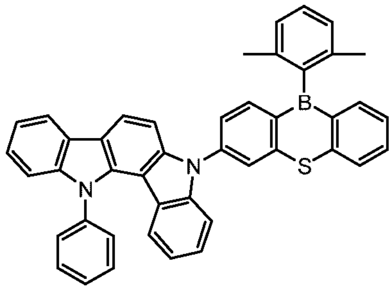

1-40

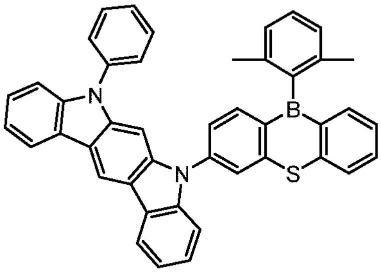

1-41

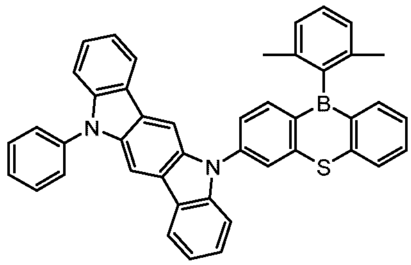

1-42

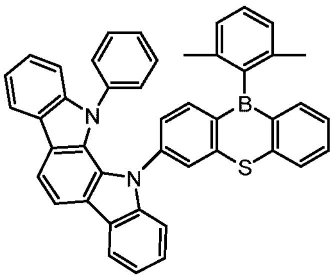

1-43

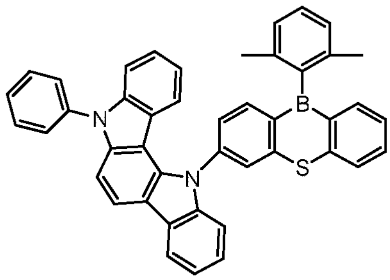

1-44

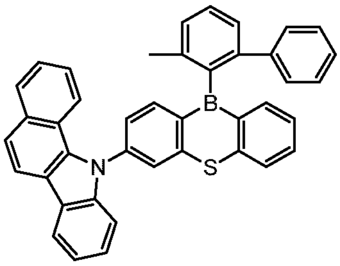

1-45

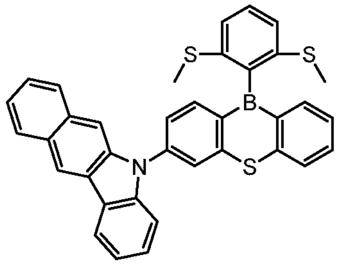

1-46

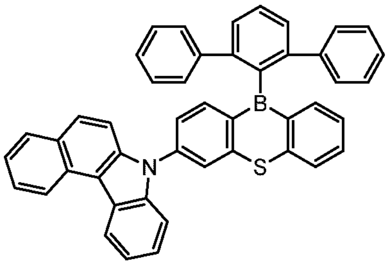

1-47

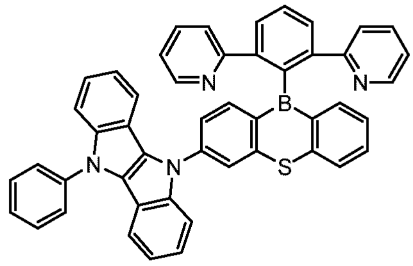

1-48

[C11]

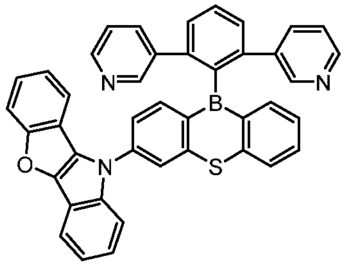

1-49

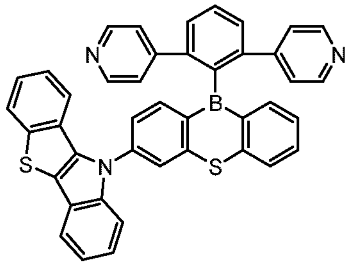

1-50

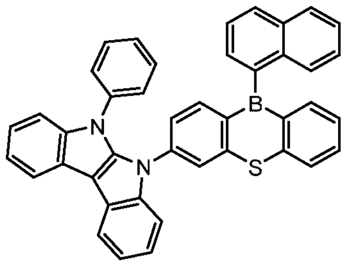

1-51

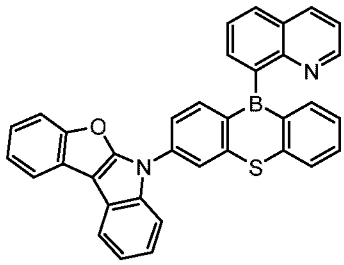

1-52

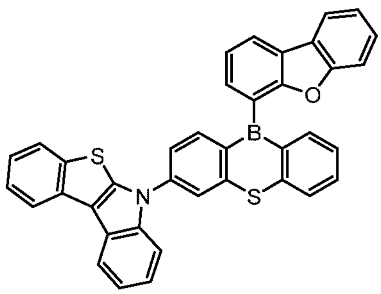

1-53

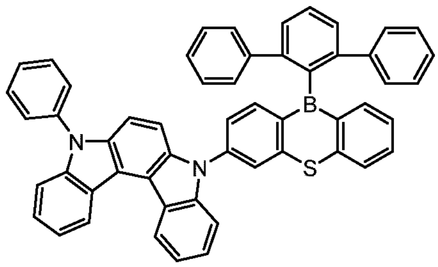

1-54

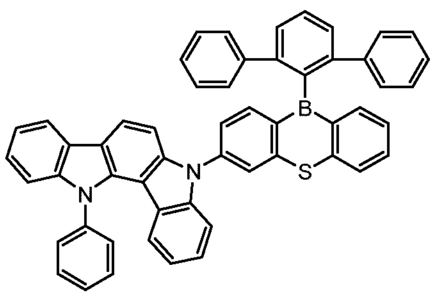

1-55

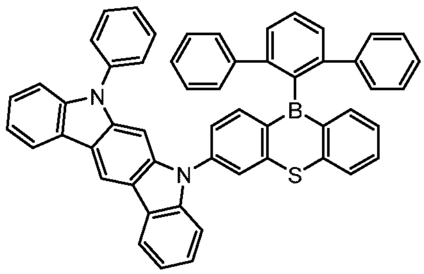

1-56

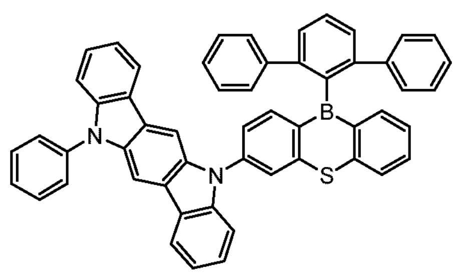

1-57

[C12]

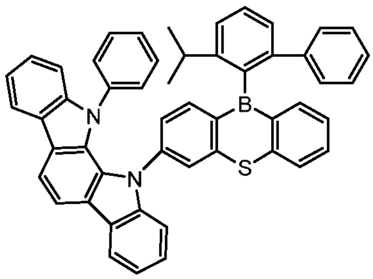

1-58

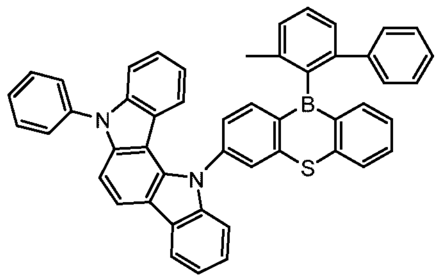

1-59

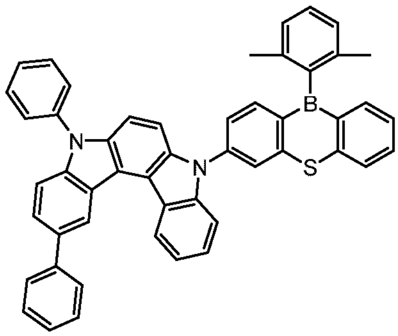

1-60

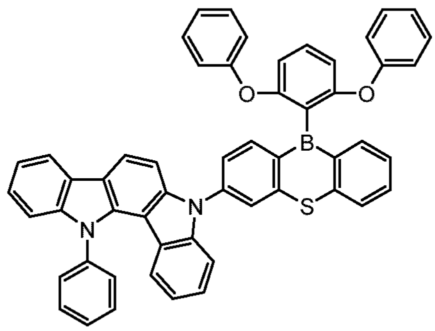

1-61

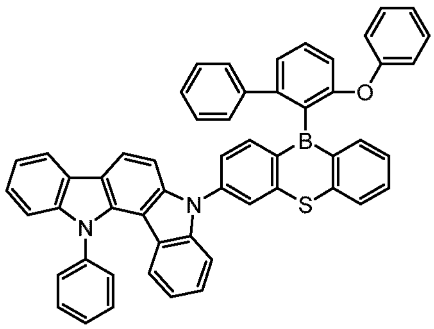

1-62

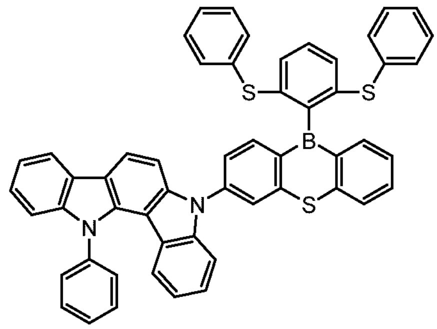

1-63

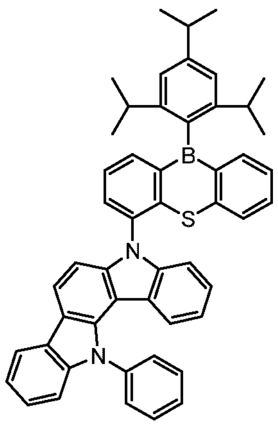

1-64

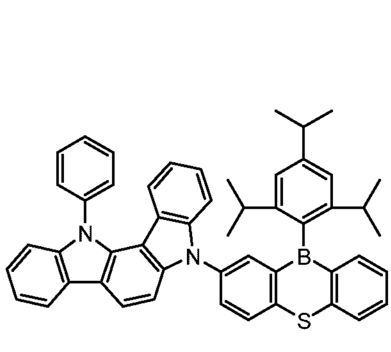

1-65

[C13]

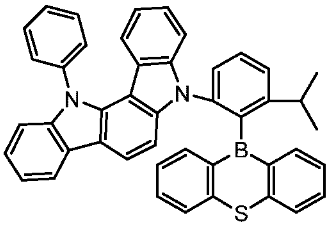
1-66

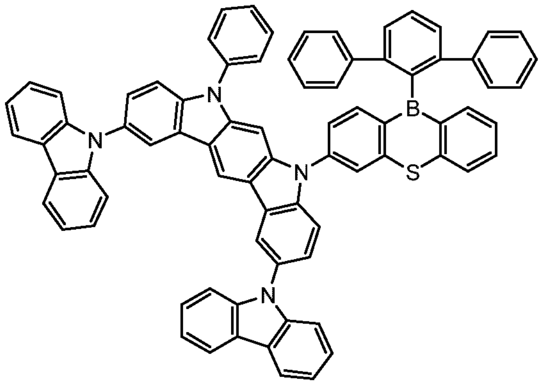
1-67

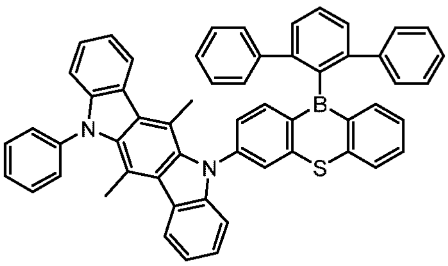
1-68

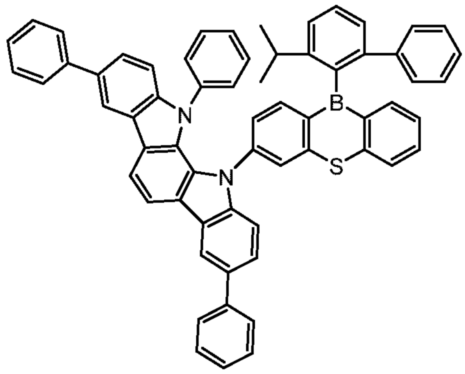
1-69

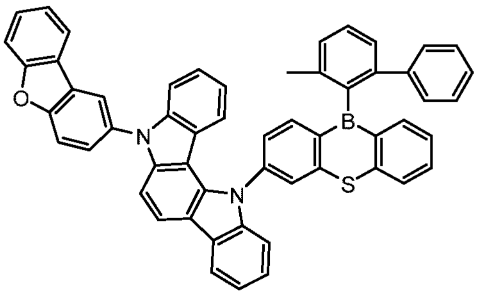
1-70

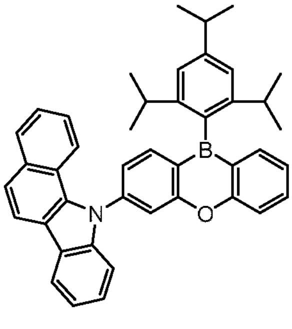
1-71

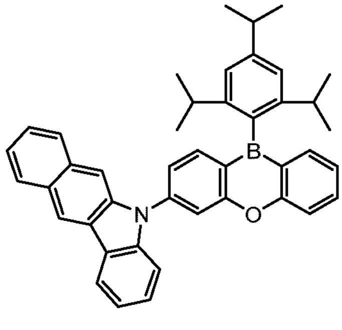
1-72

[C14]

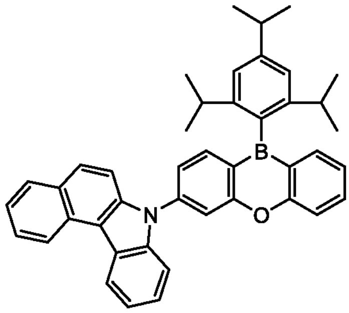

1-73

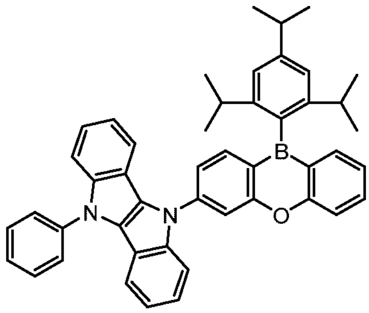

1-74

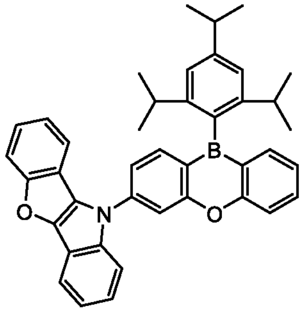

1-75

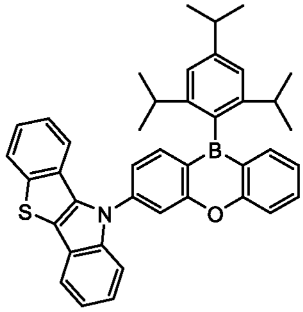

1-76

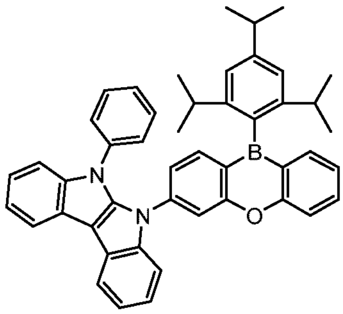

1-77

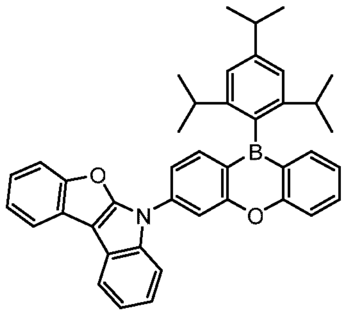

1-78

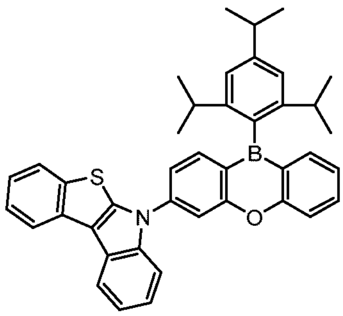

1-79

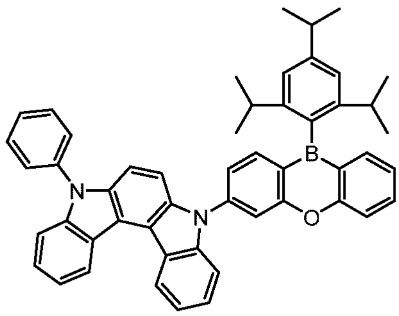

1-80

[C15]

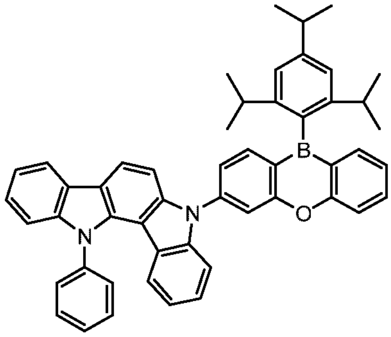

1-81

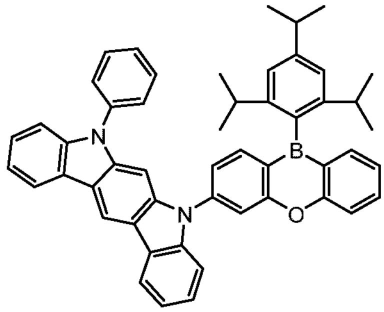

1-82

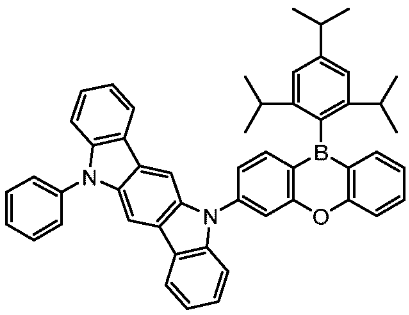

1-83

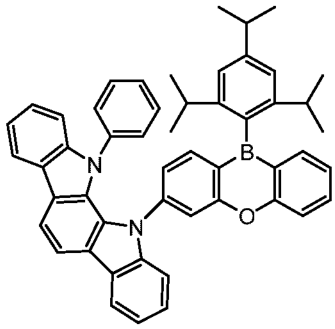

1-84

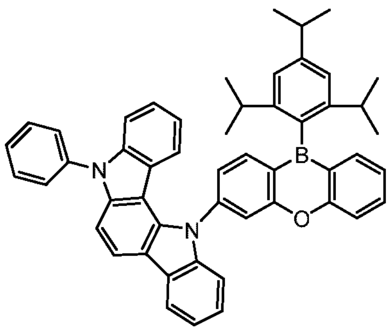

1-85

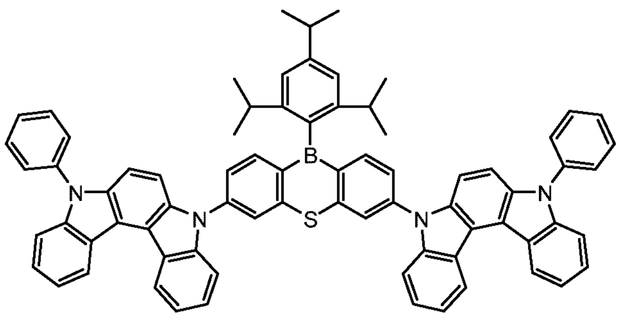

1-86

[C16]

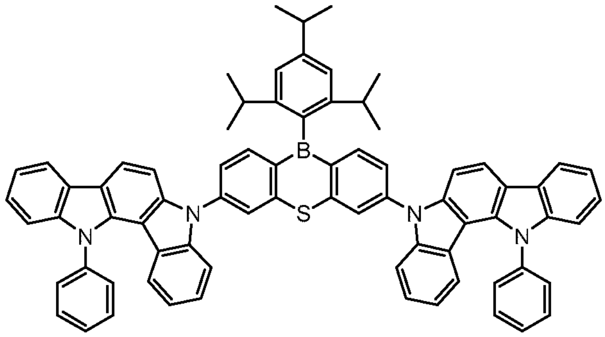

1-87

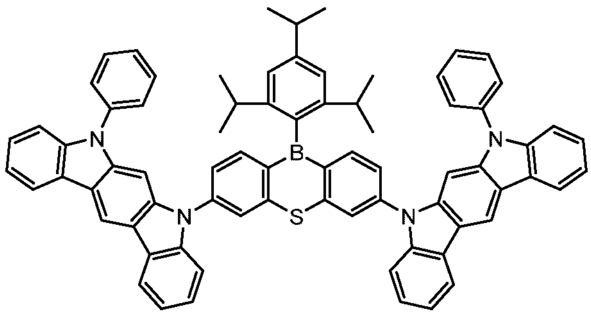

1-88

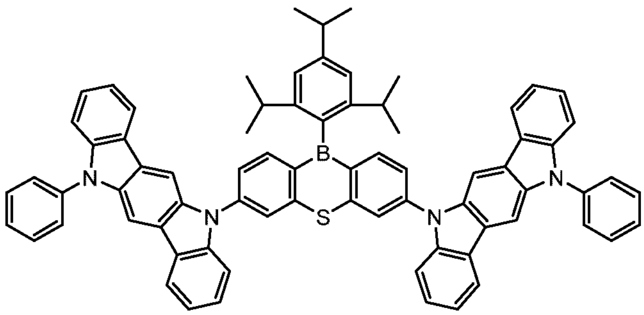

1-89

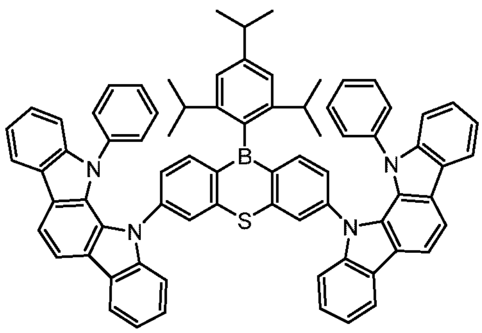

1-90

[C17]

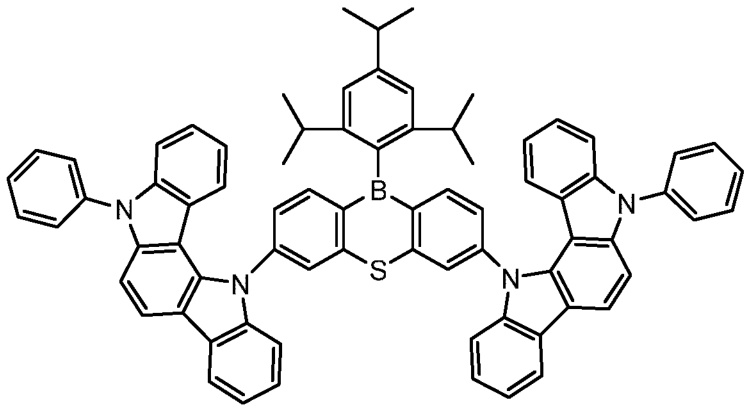

1-91

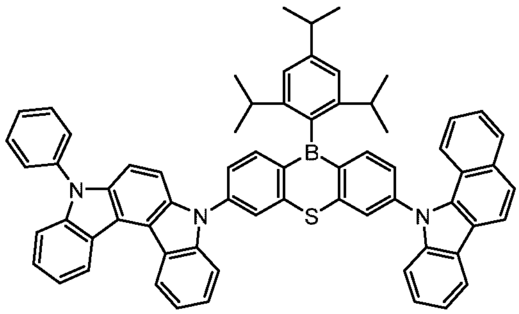

1-92

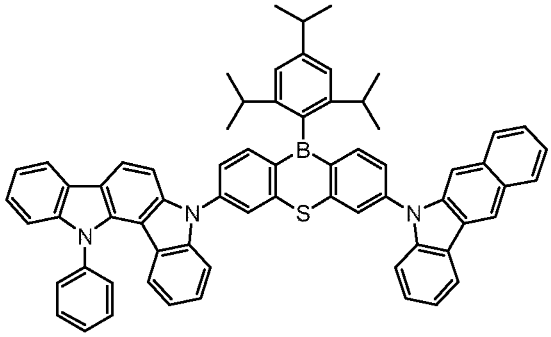

1-93

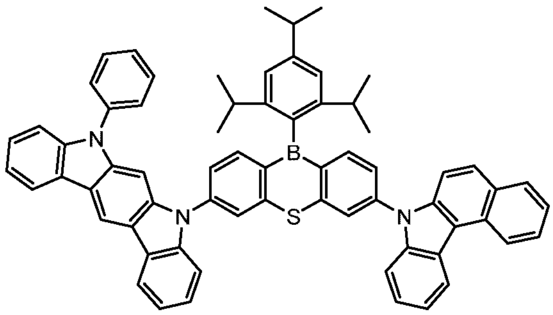

1-94

[C18]

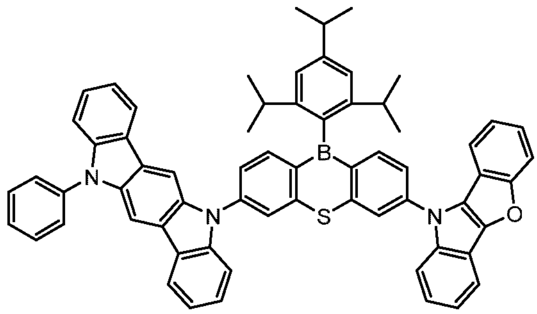

1-95

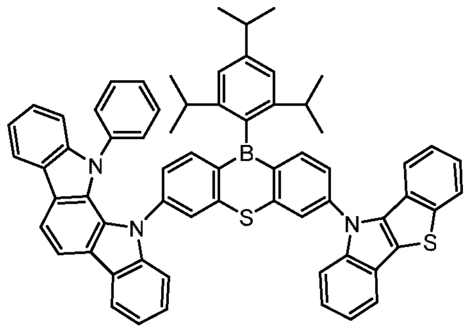

1-96

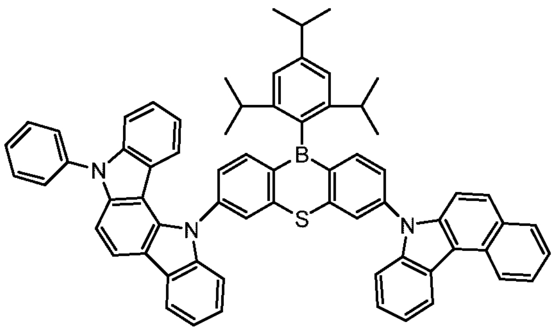

1-97

The thermally activated delayed fluorescence material represented by the general formula (1) preferably has a difference between singlet excited energy (S1) and triplet excited energy (T1) ($\Delta$EST = S1-T1) of less than 0.20 eV, and more preferably less than 0.10 eV.

Here, S1 and T1 are measured as follows.

A sample compound (thermally activated delayed fluorescence material) is deposited on a quartz substrate by a vacuum deposition method under conditions of a degree of vacuum of $10^{-4}$ Pa or less to form a deposition film having a thickness of 100 nm. For S1, the emission spectrum of this deposition film is measured, a tangent is drawn to the rise of the emission spectrum on the short-wavelength side, and the wavelength value $\lambda$edge [nm] of the point of intersection of the tangent and the horizontal axis is substituted into the following equation (i) to calculate S1.

$$S1[eV] = 1239.85/\lambda edge \qquad (i)$$

For T1, on the other hand, the phosphorescence spectrum of the above deposition film is measured, a tangent is drawn to the rise of the phosphorescence spectrum on the short-wavelength side, and the wavelength value $\lambda$edge [nm] of the point of intersection of the tangent and the horizontal axis is substituted into the following equation (ii) to calculate T1.

$$T1\ [eV] = 1239.85/\lambda edge \qquad (ii)$$

By incorporating the thermally activated delayed fluorescence material represented by the general formula (1) as a light emitting dopant or TADF material into a light emitting layer, an excellent delayed fluorescence organic EL device can be provided.

The light emitting layer can also contain a host material together with the thermally activated delayed fluorescence material represented by the general formula (1), as necessary. An excellent organic EL device can be provided by incorporating the host material thereinto.

The light emitting layer can also contain a fluorescence material other than a compound represented by the general formula (1) as a light emitting dopant together with the thermally activated delayed fluorescence material represented by the general formula (1), as necessary. An excellent organic EL device is provided by incorporating a fluorescence material thereinto. In this case, the light emitting layer can further contain a host material.

Next, the structure of the organic EL device of the present invention will be described with reference to the drawing, but the structure of the organic EL device of the present invention is not limited thereto.

Figure 1 shows a cross-sectional view of a structure example of a typical organic EL device used in the present invention. Reference numeral 1 denotes a substrate, reference numeral 2 denotes an anode, reference numeral 3 denotes a hole injection layer, reference numeral 4 denotes a hole transport layer, reference numeral 5 denotes a light emitting layer, reference numeral 6 denotes an electron transport layer, and reference numeral 7 denotes a cathode. The organic EL device of the present invention may have an exciton blocking layer adjacent to the light emitting layer, or may have an electron blocking layer between the light emitting layer and the hole injection layer. The exciton blocking layer may be inserted on either the cathode side or the anode side of the light emitting layer or may be inserted on both sides at the same time. The organic EL device of the present invention has the anode, the light emitting layer, and the cathode as essential layers, but preferably has a hole injection/transport layer and an electron injection/transport layer in addition to the essential layers, and further preferably has a hole blocking layer between the light emitting layer and the electron injection/transport layer. The hole injection/transport layer means either or both of the hole injection layer and the hole transport layer, and the electron injection/transport layer means either or both of the electron injection layer and electron transport layer.

It is also possible to have a structure that is the reverse of the structure shown in Figure 1, that is, the cathode 7, the electron transport layer 6, the light emitting layer 5, the hole transport layer 4, the hole injection layer 3, and the anode 2 can be laminated on the substrate 1, in the order presented. Also, in this case, layers can be added or omitted, as necessary. In the organic EL device as described above, layers other than electrodes such as an anode and a cathode, the layers constituting a multilayer structure on a substrate, may be collectively referred to as an organic layer in some cases.

-Substrate-

The organic EL device of the present invention is preferably supported on a substrate. The substrate is not particularly limited and may be a substrate conventionally used for organic EL devices, and for example, a substrate made of glass, transparent plastic, or quartz can be used.

-Anode-

As the anode material in the organic EL device, a material made of a metal, alloy, or conductive compound having a high work function (4 eV or more), or a mixture thereof is preferably used. Specific examples of such an electrode material include metals such as Au, and conductive transparent materials such as CuI, indium tin oxide (ITO), $SnO_2$, and ZnO. An amorphous material capable of producing a transparent conductive film such as IDIXO ($In_2O_3$-ZnO) may also be used. As the anode, these electrode materials may be formed into a thin film by a method such as vapor deposition or sputtering, and then a pattern of a desired form may be formed by photolithography. Alternatively, when a highly precise pattern is not required (about 100 $\mu$m or more), a pattern may be formed through a mask of a desired form at the time of vapor deposition or sputtering of the above electrode materials. Alternatively, when a coatable material such as an organic conductive compound is used, a wet film forming method such as a printing method and a coating method can also be used. When light is extracted from the anode, the transmittance is desirably more than 10%, and the sheet resistance as the anode is preferably several hundred $\Omega$/square or less. The film thickness is selected within a range of usually 10 to 1,000 nm, and preferably 10 to 200 nm, although it depends on the material.

-Cathode-

On the other hand, a material made of a metal (referred to as an electron injection metal), alloy, or conductive compound having a low work function (4 eV or less) or a mixture thereof is used as the cathode material. Specific examples of such an electrode material include sodium, a sodium-potassium alloy, magnesium, lithium, a magnesium/copper mixture, a magnesium/silver mixture, a magnesium/aluminum mixture, a magnesium/indium mixture, an aluminum/aluminum oxide ($Al_2O_3$) mixture, indium, a lithium/aluminum mixture, and a rare earth metal. Among them, in terms of electron injection properties and durability against oxidation and the like, a mixture of an electron injection metal with a second metal that has a higher work function value than the electron injection metal and is stable, for example, a magnesium/silver mixture, a magnesium/aluminum mixture, a magnesium/indium mixture, an aluminum/aluminum oxide ($Al_2O_3$) mixture, a lithium/aluminum mixture, or aluminum is suitable. The cathode can be produced by forming a thin film from these cathode materials by a method such as vapor deposition and sputtering. The sheet resistance as the cathode is preferably several hundred $\Omega$/square or less, and the film thickness is selected within a range of usually 10 nm to 5 $\mu$m, and preferably 50 to 200 nm. To transmit the light emitted, either one of the anode and the cathode of the organic EL device is favorably transparent or translucent because light emission brightness is improved.

The above metal is formed to have a film thickness of 1 to 20 nm on the cathode, and then a conductive transparent material mentioned in the description of the anode is formed on the metal, so that a transparent or translucent cathode can be produced. By applying this process, a device in which both anode and cathode have transmittance can be produced.

-Light Emitting Layer-

The light emitting layer is a layer that emits light after holes and electrons respectively injected from the anode and the cathode are recombined to form exciton. For the light emitting layer, the TADF material represented by the general formula (1) may be used alone, or the TADF material may be used in combination with a host material. When the TADF material is used together with host material, the TADF material serves as a light emitting dopant.

The TADF material represented by the general formula (1) may also be used together with a fluorescence material other than those represented by the general formula (1). When the TADF material represented by the general formula (1) is used together with the fluorescence material, the TADF material may be further used together with a host material. When the TADF material represented by the general formula (1) is used together with a fluorescence material, the fluorescence material serves as a light emitting dopant.

The content of the light emitting dopant is preferably 0.1 to 50 wt%, and more preferably 1 to 40 wt% based on the host material.

The host material in the light emitting layer can be a known host material used for a phosphorescent device or a fluorescent device. A usable known host material is a compound having the ability to transport hole, the ability to transport electron, and a high glass transition temperature, and preferably has a higher T1 than the T1 of the TADF material represented by the general formula (1). A TADF-active compound may also be used as the host material, and the TADF-active compound preferably has $\Delta$EST of 0.20 eV or less.

Known hosts are known in a large number of patent literatures and the like, and hence may be selected from them. Specific examples of the host include, but are not particularly limited to, various metal complexes typified by metal complexes of indole derivatives, carbazole derivatives, indolocarbazole derivatives, triazole derivatives, oxazole derivatives, oxadiazole derivatives, imidazole derivatives, phenylenediamine derivatives, arylamine derivatives, styrylanthracene derivatives, fluorenone derivatives, stilbene derivatives, triphenylene derivatives, carborane derivatives, porphyrin derivatives, phthalocyanine derivatives, and 8-quinolinol derivatives, and metal phthalocyanine, and metal complexes of benzoxazole and benzothiazole derivatives; and polymer compounds such as poly(N-vinyl carbazole)derivatives, aniline-based copolymers, thiophene oligomers, polythiophene derivatives, polyphenylene derivatives, polyphenylene vinylene derivatives, and polyfluorene derivatives.

When a plurality of hosts is used, each host is deposited from different deposition sources, or a plurality of hosts is premixed before vapor deposition to form a premix, whereby a plurality of hosts can be simultaneously deposited from one deposition source.

As the method of premixing, a method by which hosts can be mixed as uniformly as possible is desirable, and examples thereof include, but are not limited to, milling, a method of heating and melting hosts under reduced pressure or under an inert gas atmosphere such as nitrogen, and sublimation.

The host and a premix thereof may be in the form of powder, sticks, or granules.

Preferred examples of the host specifically include, but are not particularly limited to, the following.

[C19]

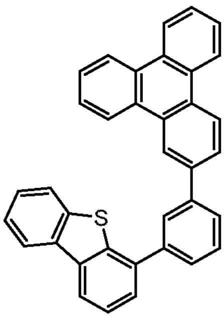
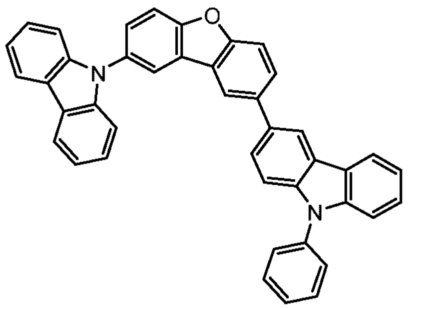
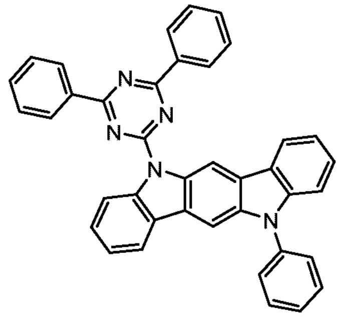
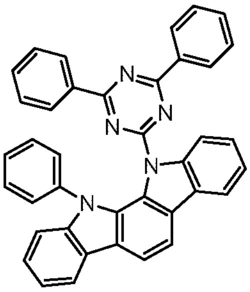
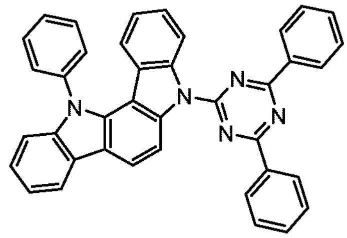
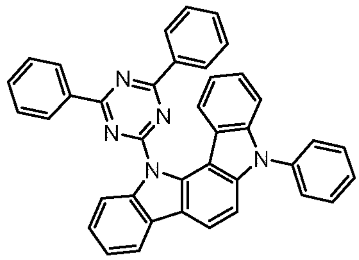
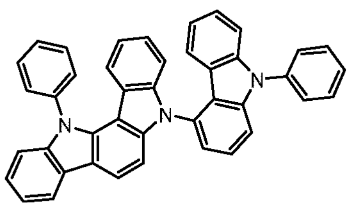
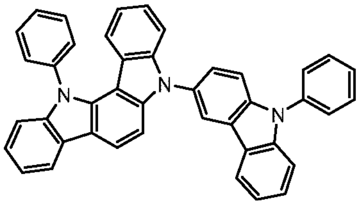
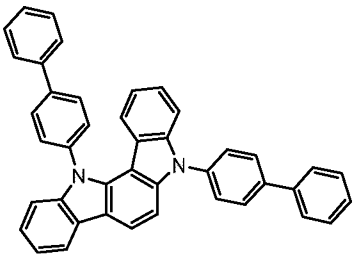

[C20]

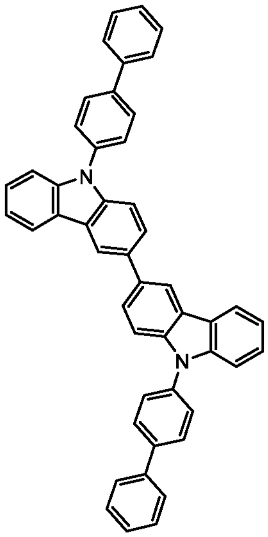
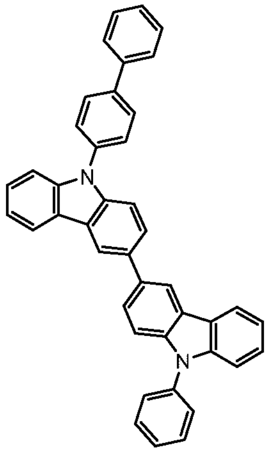
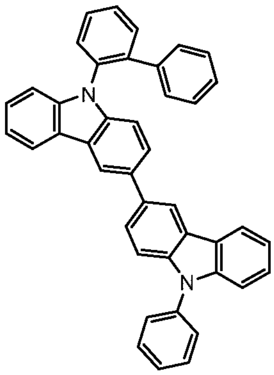
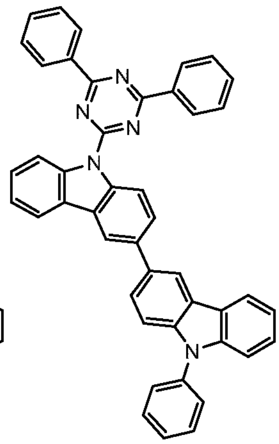
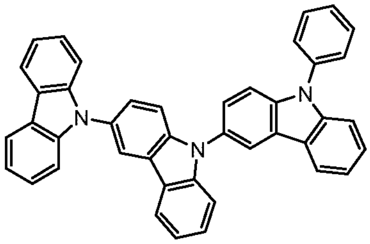
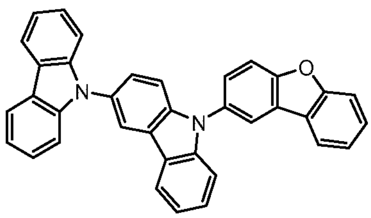
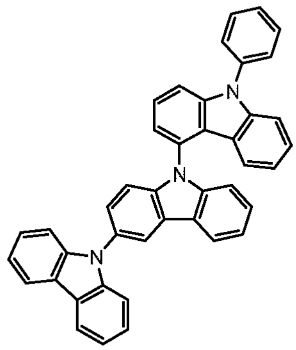
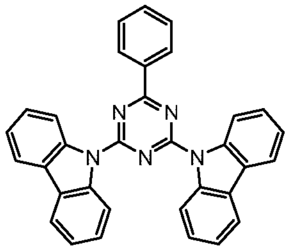

When a fluorescence material other than those represented by the general formula (1) is used in the light emitting layer, preferred examples of the other fluorescence material include fused polycyclic aromatic derivatives, styrylamine derivatives, fused ring amine derivatives, boron-containing compounds, pyrrole derivatives, indole derivatives, carbazole derivatives, and indolocarbazole derivatives. Among them, fused ring amine derivatives, boron-containing compounds, carbazole derivatives, and indolocarbazole derivatives are preferred.

Examples of the fused ring amine derivatives include diaminepyrene derivatives, diaminochrysene derivatives, diaminoanthracene derivatives, diaminofluorenone derivatives, and diaminofluorene derivatives fused with one or more benzofuro backbones.

Examples of the boron-containing compounds include pyrromethene derivatives and trriphenylborane derivatives.

Preferred examples of the fluorescence material other than those represented by the general formula (1) are not particularly limited, but specific examples thereof include the following.

[C21]

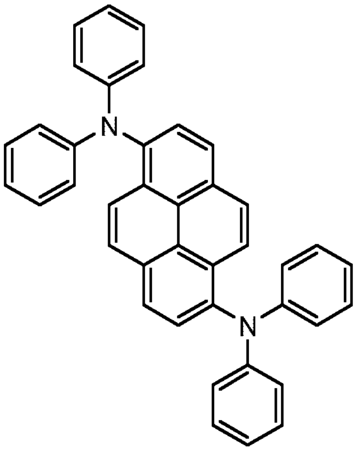

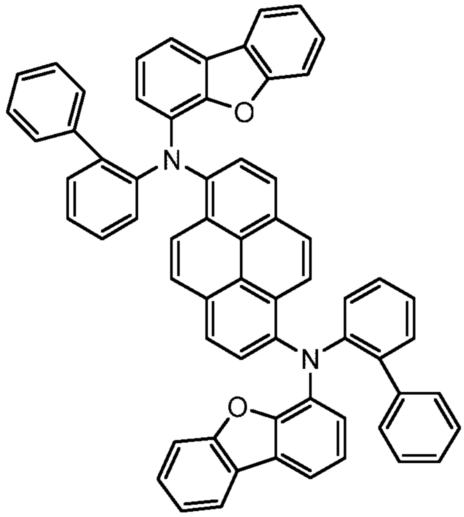

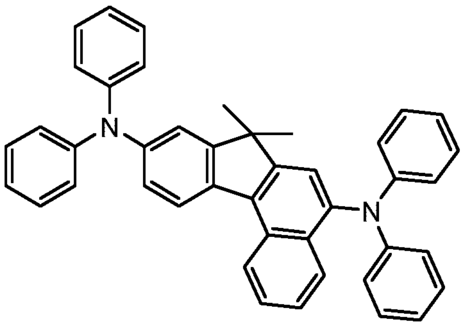

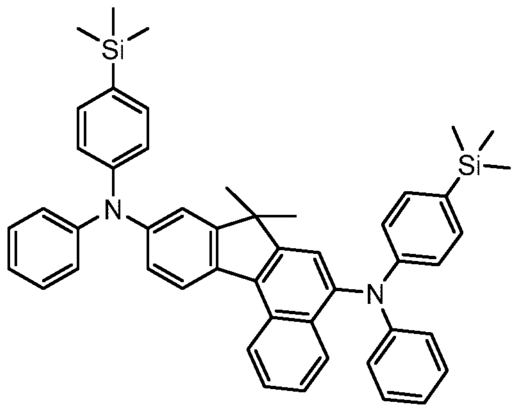

[C22]

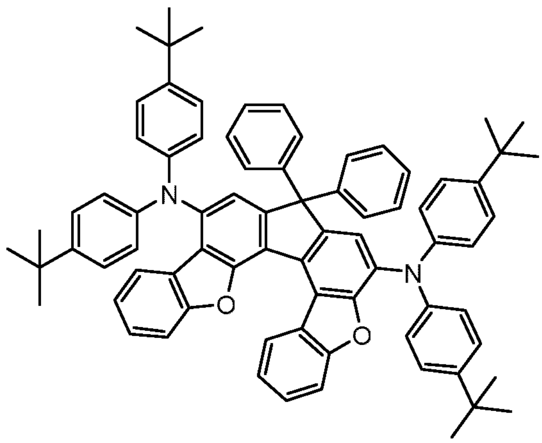

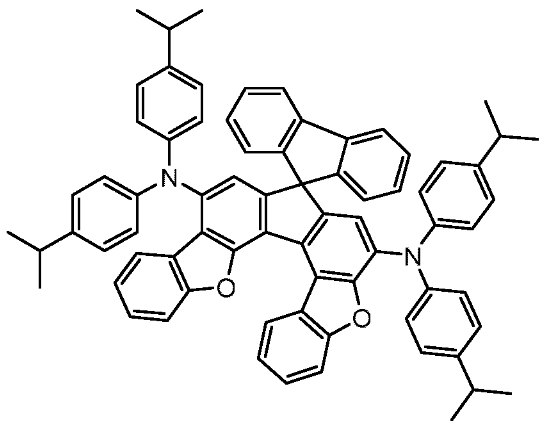

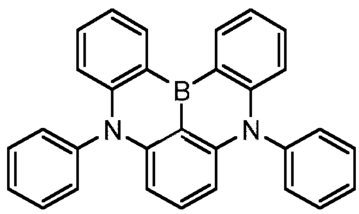

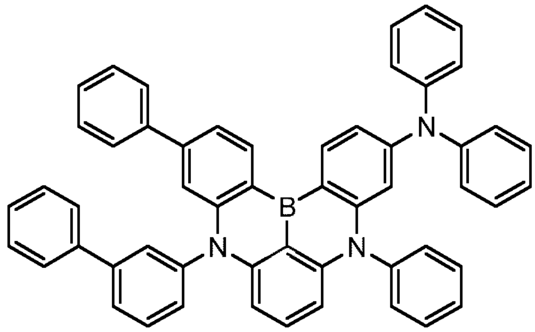

[C23]

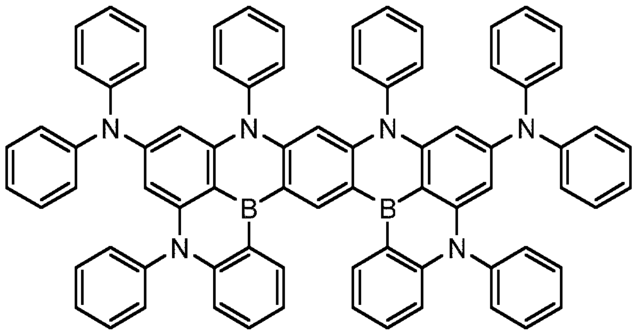

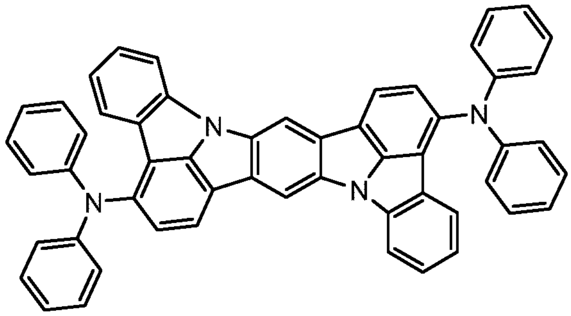

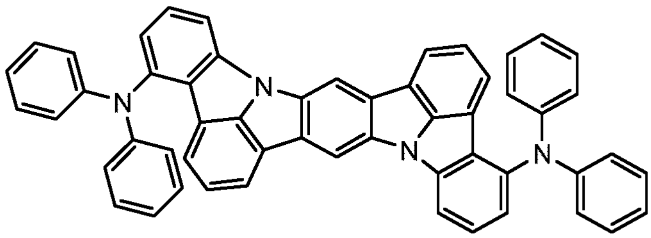

-Injection Layer-

The injection layer refers to a layer provided between the electrode and the organic layer to reduce the driving voltage and improve the light emission brightness, and includes the hole injection layer and the electron injection layer. The injection layer may be present between the anode and the light emitting layer or the hole transport layer, as well as between the cathode and the light emitting layer or the electron transport layer. The injection layer may be provided as necessary.

-Hole Blocking Layer-

The hole blocking layer has the function of the electron transport layer in a broad sense, is made of a hole blocking material having a very small ability to transport holes while having the function of transporting electrons, and can improve the recombination probability between the electrons and the holes in the light emitting layer by blocking the holes while transporting the electrons. For the hole blocking layer, a known hole blocking material can be used. A plurality of hole blocking materials may be used in combination.

-Electron Blocking Layer-

The electron blocking layer has the function of the hole transport layer in a broad sense, and can improve the recombination probability between the electrons and the holes in the light emitting layer by blocking the electrons while transporting the holes. As the material for the electron blocking layer, a known material for the electron blocking layer can be used.

-Exciton Blocking Layer-

The exciton blocking layer is a layer to block the diffusion of the excitons generated by recombination of the holes and the electrons in the light emitting layer into a charge transport layer, and insertion of this layer makes it possible to efficiently keep the excitons in the light emitting layer, so that the emission efficiency of the device can be improved. The exciton blocking layer can be inserted between two light emitting layers adjacent to each other in the device in which two or more light emitting layers are adjacent to each other. As the material for such an exciton blocking layer, a known material for the exciton blocking layer can be used.

The layer adjacent to the light emitting layer includes the hole blocking layer, the electron blocking layer, and the exciton blocking layer, and when these layers are not provided, the adjacent layer is the hole transport layer, the electron transport layer, and the like.

-Hole Transport Layer-

The hole transport layer is made of a hole transport material having the function of transporting holes, and the hole transport layer may be provided as a single layer or a plurality of layers.

The hole transport material has any of hole injection properties, hole transport properties, or electron barrier properties, and may be either an organic material or an inorganic material. As the hole transport layer, any of conventionally known compounds may be selected and used. Examples of such a hole transport material include porphyrin derivatives, arylamine derivatives, triazole derivatives, oxadiazole derivatives, imidazole derivatives, polyarylalkane derivatives, phenylenediamine derivatives, arylamine derivatives, amino-substituted chalcone derivatives, oxazole derivatives, styrylanthracene derivatives, fluorenone derivatives, hydrazone derivatives, stilbene derivatives, silazane derivatives, aniline-based copolymers, and conductive polymer oligomers, particularly, thiophene oligomers. Porphyrin derivatives, arylamine derivatives, and styrylamine derivatives are preferably used, and arylamine compounds are more preferably used.

-Electron Transport Layer-

The electron transport layer is made of a material having the function of transporting electrons, and the electron transport layer may be provided as a single layer or a plurality of layers.

The electron transport material (may also serve as the hole blocking material) has the function of transmitting electrons injected from the cathode to the light emitting layer. As the electron transport layer, any of conventionally known compounds may be selected and used, and examples thereof include polycyclic aromatic derivatives such as naphthalene, anthracene, and phenanthroline, tris(8-quinolinolato)aluminum (III) derivatives, phosphine oxide derivatives, nitro-substituted fluorene derivatives, diphenylquinone derivatives, thiopyran dioxide derivatives, carbodiimides, fluorenylidene methane derivatives, anthraquinodimethane and anthrone derivatives, bipyridine derivatives, quinoline derivatives, oxadiazole derivatives, benzimidazole derivatives, benzothiazole derivatives, and indolocarbazole derivatives. Further, polymer materials in which these materials are introduced in the polymer chain or these materials constitute the main chain of the polymer can also be used.

When the organic EL device of the present invention is produced, the film formation method of each layer is not particularly limited, and the layers may be produced by either a dry process or a wet process.

Examples

Hereinafter, the present invention will be described in further detail with reference to Examples, but the present invention is not limited to these Examples.

The compounds used in Examples and Comparative Examples are shown below.

[C24]

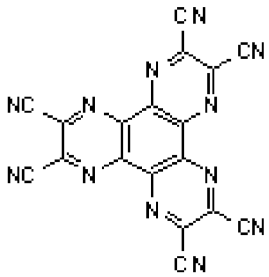

HAT-CN

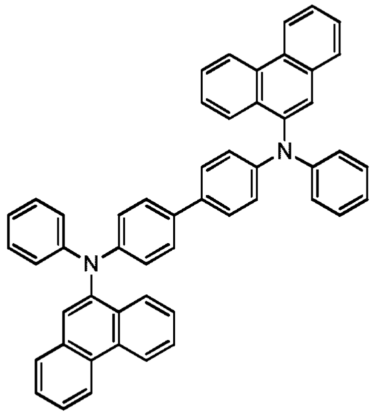

HT-1

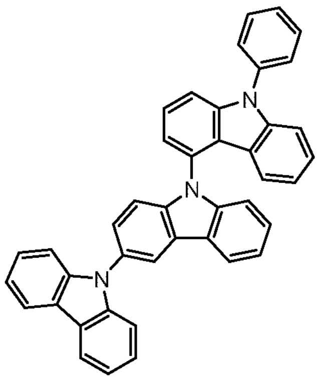

BH-1

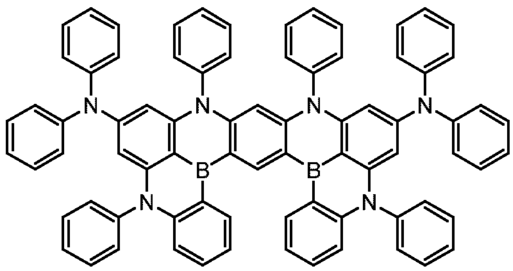

BD-1

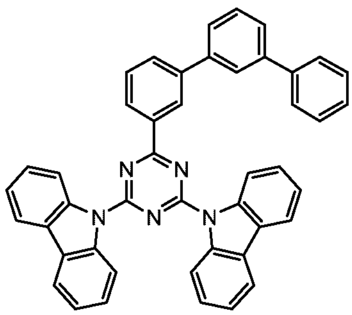

HBL-1

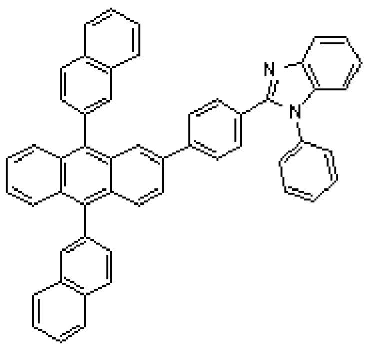

ET-1

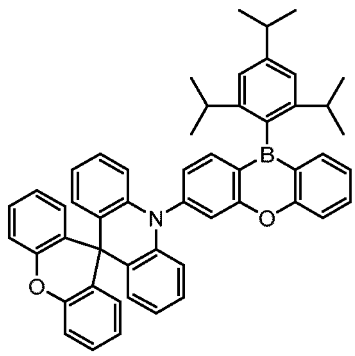

TD-1

Synthesis Example 1

[C25]

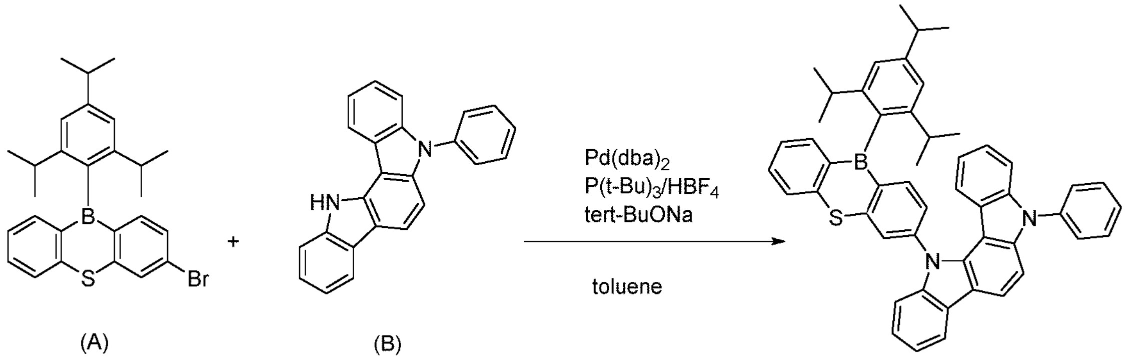


(A) (B) (1-15)

As shown in the above reaction scheme, 2.0 g of a starting material (A), 1.5 g of a starting material (B), 0.24 g of tri-tert-butylphosphonium tetrafluoroborate [$P(t-Bu)_3/HBF_4$], 1.2 g of sodium tert-butoxide (tert-BuONa), and 42 ml of toluene were put in a three-necked flask under a nitrogen atmosphere and stirred at 80°C for 15 minutes. Then, 0.12 g of bis(dibenzylideneacetone)palladium(0) [$Pd(dba)_2$] was added thereto and the mixture was stirred at 110°C for 30 minutes. After the reaction solution was cooled to room temperature, the reaction solution was washed with water, and the organic layer was concentrated. The concentrate was purified by silica gel column chromatography, then 21 g of toluene was added to the concentrate, and the mixture was heated and dissolved at 110°C. Thereafter, 10 g of isopropyl alcohol was added thereto and the mixture was cooled to room temperature. The precipitated solid was collected by filtering, and the resulting solid was dried under reduced pressure to yield 2.3 g of a compound (1-15) (yield: 75%).
APCI-TOFMS m/z 729[M+1]

Synthesis Example 2

[C26]

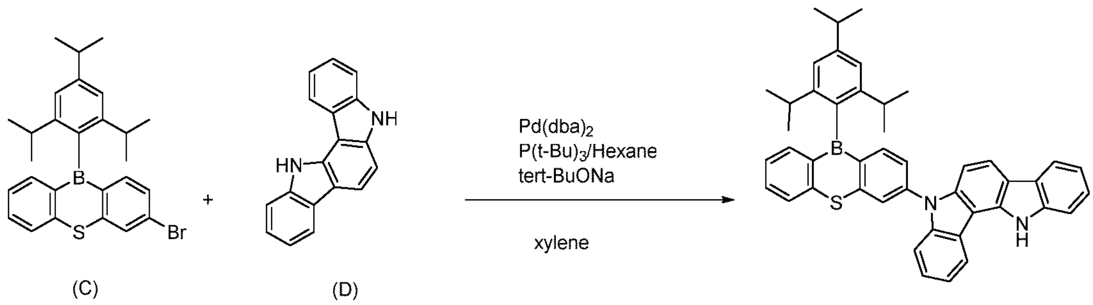


(C) (D) (E)

As shown in the above reaction scheme, 2.60 g of a starting material (C), 2.79 g of a starting material (D), 1.57 g of tert-BuONa, and 55 ml of xylene were put in a three-necked flask under a nitrogen atmosphere and stirred at room temperature for 20 minutes. Then, 2.22 g of tri-tert-butylphosphine hexane solution [$P(t-Bu)_3$/Hexane (10 wt% in hexane)] and 0.16 g of $Pd(dba)_2$ were added thereto and the mixture was stirred at 90°C for 30 minutes. After the reaction solution was cooled to room temperature, the reaction solution was filtered, and the organic layer was concentrated. The concentrate was purified by silica gel column chromatography, and then the resulting solid was dried under reduced pressure to yield 2.70 g of a compound (E) (yield: 76%).

[C27]

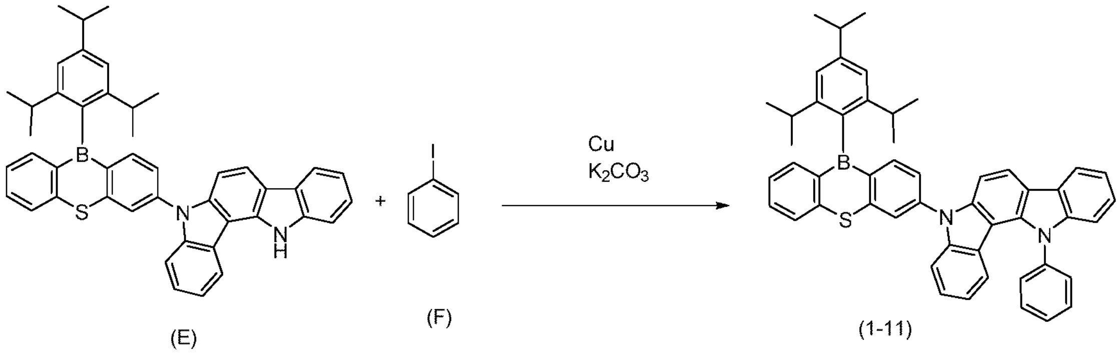


(E) (F) (1-11)

Next, 2.50 g of the intermediate (E) obtained above, 23.44 g of a starting material (F), 1.46 g of copper, and 5.82 g of potassium carbonate were put into a three-necked flask and stirred at 190°C for 2.5 hours under a nitrogen atmosphere. After the reaction solution was cooled to room temperature, the reaction solution was filtered. The resulting solution was concentrated, and the concentrate was purified by silica gel column chromatography. After 40 g of isopropyl alcohol was added to the resulting solid, the mixture was heated for 1 hour while stirred, and then cooled to room temperature. The solid was collected by filtering and dried under reduced pressure to yield 2.20 g of a compound (1-11) (yield: 79%).
APCI-TOFMS m/z 729[M+1]

Synthesis Example 3

[C28]

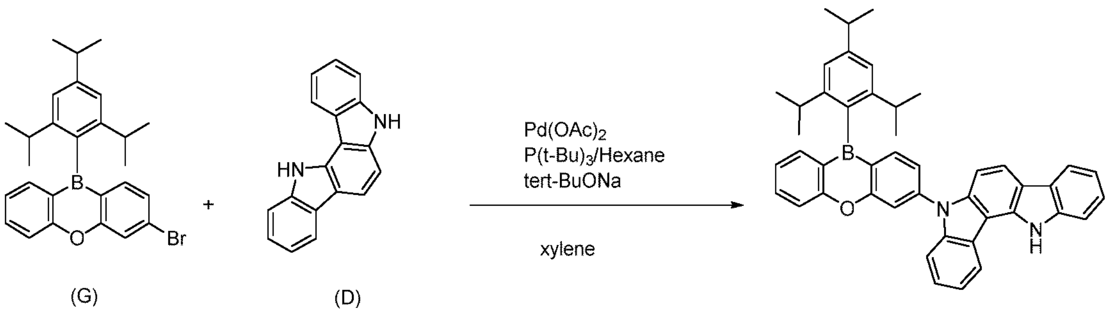


(G) (D) (H)

As shown in the above reaction scheme, 4.00 g of a starting material (G), 2.22 g of the starting material (D), 1.67 g of tert-BuONa, 0.10 g of palladium (II) acetate [$Pd(OAc)_2$], and 300 ml of xylene were put in a three-necked flask under a nitrogen atmosphere and stirred at room temperature for 20 minutes. 0.88 g of $P(t\text{-}Bu)_3$/Hexane (10 wt% in hexane) was added thereto and the mixture was stirred at 140°C for 3 hours. After the reaction solution was cooled to room temperature, the reaction solution was filtered, and the organic layer was concentrated. The concentrate was purified by silica gel column chromatography, and then the resulting solid was dried under reduced pressure to yield 1.49 g of a compound (H) (yield: 27%).

[C29]

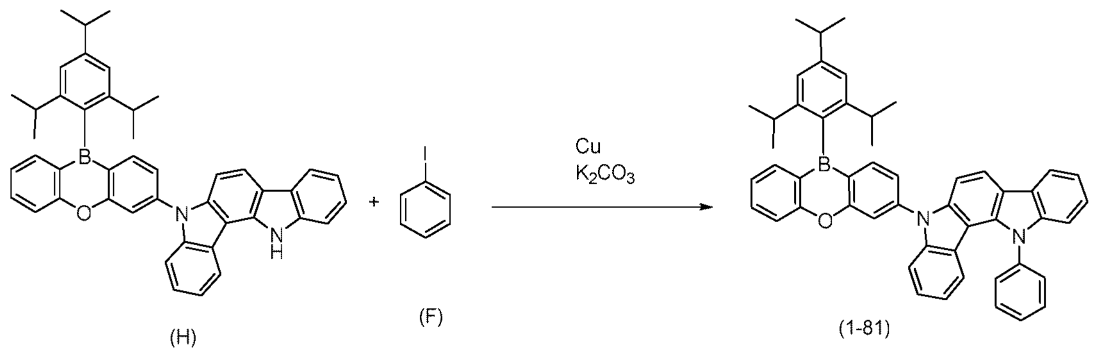


Subsequently, 1.49 g of the intermediate (H) obtained above, 183 g of the starting material (F), 0.97 g of copper, and 3.56 g of potassium carbonate were put in a three-necked flask and stirred at 190°C for 6 hours under a nitrogen atmosphere. After the reaction solution was cooled to room temperature, the reaction solution was filtered, the resulting solution was concentrated, and the concentrate was purified by silica gel column chromatography. 100g of isopropyl alcohol was added to the resulting solid, and the mixture was heated for 2 hours while stirred, and then cooled to room temperature. The solid was collected by filtering and dried under reduced pressure to yield 1.28 g of a compound (1-81) (yield: 77%).
APCI-TOFMS m/z 716[M+1]

Experiment Example 1

The fluorescence lifetime of the compound 1-15 obtained in Synthesis Example 1 was measured as follows.
First, the compound 1-15 and BH-1 shown hereinabove were deposited on a quartz substrate from different deposition sources by a vacuum deposition method under conditions of a degree of vacuum of $10^{-4}$ Pa or less to form a co-deposition film having a thickness of 100 nm such that the concentration of the compound 1-15 was 30% by mass. When the emission spectrum of this thin film was measured, it was confirmed that the emission peaked at 473 nm. The emission lifetime was also measured by a compact fluorescence lifetime measuring apparatus (Quantaurus-tau, manufactured by Hamamatsu Photonics K.K.) under a nitrogen atmosphere. The fluorescence emission with an emission lifetime of 1.6 ns and the delayed fluorescence emission with an emission lifetime of 1.9 μs were observed, which confirmed that the compound 1-15 is a compound showing delayed fluorescence emission.

Experiment Example 2

The fluorescence lifetime of the compound 1-11 obtained in Synthesis Example 2 was measured as follows.
First, the compound 1-11 and BH-1 shown hereinabove were deposited on a quartz substrate from different deposition sources by a vacuum deposition method under conditions of a degree of vacuum of $10^{-4}$ Pa or less to form a co-deposition film having a thickness of 100 nm such that the concentration of the compound 1-11 was 30% by mass. When the emission spectrum of this thin film was measured, it was confirmed that the emission peaked at 473 nm. The emission lifetime was also measured by a compact fluorescence lifetime measuring apparatus (Quantaurus-tau, manufactured by Hamamatsu Photonics K.K.) under a nitrogen atmosphere. The fluorescence emission with an emission lifetime of 2.0 ns and the delayed fluorescence emission with an emission lifetime of 1.7 μs were observed, which confirmed that the compound 1-11 is a compound showing delayed fluorescence emission.

Experiment Example 3

The fluorescence lifetime of the compound 1-81 obtained in Synthesis Example 3 was measured as follows.
First, the compound 1-81 and BH-1 shown hereinabove were deposited on a quartz substrate from different deposition sources by a vacuum deposition method under conditions of a degree of vacuum of $10^{-4}$ Pa or less to form a co-deposition film having a thickness of 100 nm such that the concentration of the compound 1-81 was 30% by mass. When the emission spectrum of this thin film was measured, it was confirmed that the emission peaked at 455 nm. The emission lifetime was also measured by a compact fluorescence lifetime measuring apparatus (Quantaurus-tau, manufactured by Hamamatsu Photonics K.K.) under a nitrogen atmosphere. The fluorescence emission with an emission lifetime of 7.4 ns and the delayed fluorescence emission with an emission lifetime of 1.5 μs were observed, which

confirmed that the compound 1-81 is a compound showing delayed fluorescence emission.

Experiment Example 4

The fluorescence lifetime of TD-1 described in Patent Literature 4 was measured as follows.

First, TD-1 and the previously presented BH-1 were deposited on a quartz substrate from different deposition sources by a vacuum deposition method under conditions of a degree of vacuum of $10^{-4}$ Pa or less to form a co-deposition film having a thickness of 100 nm such that the concentration of the TD-1 was 30% by mass. When the emission spectrum of this thin film was measured, it was confirmed that the emission peaked at 454 nm. The emission lifetime was also measured by a compact fluorescence lifetime measuring apparatus (Quantaurus-tau, manufactured by Hamamatsu Photonics K.K.) under a nitrogen atmosphere. The fluorescence emission with an emission lifetime of 12.7 ns and the delayed fluorescence emission with an emission lifetime of 1.0 μs were observed, which confirmed that the TD-1 is a compound showing delayed fluorescence emission.

S1 and T1 of the compounds 1-15, 1-11, 1-81, and TD-1, were each measured for the co-deposition films obtained in Experiment Example 1 and Experiment Example 2. The measurement method and calculation method are the same as the methods described above.

[Table 1]

| Compound | S1 [eV] | T1[eV] | S1-T1[ev] |
|---|---|---|---|
| 1-15 | 2.88 | 2.83 | 0.05 |
| 1-11 | 2.82 | 2.79 | 0.03 |
| 1-81 | 2.99 | 2.83 | 0.16 |
| TD-1 | 2.91 | 2.85 | 0.10 |

Example 1

Each thin film shown below was laminated on the glass substrate on which an anode made of ITO having a film thickness of 70 nm was formed by a vacuum deposition method at a degree of vacuum of $4.0 \times 10^{-5}$ Pa. First, the previously presented HAT-CN was formed on ITO to a thickness of 10 nm as a hole injection layer, and then HT-1 was formed to a thickness of 25 nm as a hole transport layer. Then, BH-1 was formed to a thickness of 5 nm as an electron blocking layer. Then, BH-1 as the host and a compound (1-15) as the dopant were co-deposited from different deposition sources to form a light emitting layer having a thickness of 30 nm. At this time, they were co-deposited under deposition conditions such that the concentration of the compound (1-15) was 30% by mass. Then, HBL-1 was formed to a thickness of 5 nm as a hole blocking layer. Then, ET-1 was formed to a thickness of 40 nm as an electron transport layer. Further, lithium fluoride (LiF) was formed on the electron transport layer to a thickness of 1 nm as an electron injection layer. Finally, aluminum (Al) was formed on the electron injection layer to a thickness of 70 nm as a cathode, whereby an organic EL device according to Example 1 was produced.

Example 2

Each organic EL device was produced in the same manner as in Example 1, except that the dopant was changed to the compound (1-11).

Example 3

Each organic EL device was produced in the same manner as in Example 1, except that the dopant was changed to the compounds (1-81).

Example 4

Each thin film shown below was laminated on the glass substrate on which an anode made of ITO having a film thickness of 70 nm was formed, by a vacuum deposition method at a degree of vacuum of $4.0 \times 10^{-5}$ Pa. First, the previously presented HAT-CN was formed on ITO to a thickness of 10 nm as a hole injection layer, and then HT-1 was formed to a thickness of 25 nm as a hole transport layer. Then, BH-1 was formed to a thickness of 5 nm as an electron blocking layer. Then, BH-1 as the host, the compound (1-11) as the TADF material, and BD-1 as the dopant were co-deposited from different deposition sources to form a light emitting layer having a thickness of 30 nm. At this time, they were co-deposited under deposition conditions such that the concentrations of BH-1, the compound (1-11), and BD-1 were 69% by mass, 29% by mass, and 2% by mass, respectively. Then, HBL-1 was formed to a thickness of 5 nm as a hole blocking layer. Then, ET-1 was formed to a thickness of 40 nm as an electron transport layer. Further, lithium fluoride (LiF) was formed on the electron transport layer to a thickness of 1 nm as an electron injection layer. Finally, aluminum (Al) was formed on the electron injection layer to a thickness of 70 nm as a cathode, whereby an organic EL device according to Example 4 was produced.

Comparative Example 1

Each organic EL device was produced in the same manner as in Example 1, except that the dopant was changed to the TD-1.

The maximum emission wavelength of the emission spectrum, external quantum efficiency, and lifetime of each organic EL device produced are shown in Table 2. The maximum emission wavelength and the external quantum efficiency were values at a driving current density of 2.5 mA/$cm^2$ and were initial characteristics. The time taken for the luminance to reduce to 50% of the initial luminance when the initial luminance was 500 cd/$m^2$ was measured as the lifetime.

[Table 2]

| | Maximum emission wavelength (nm) | External quantum efficiency (%) | Lifetime (h) |
|---|---|---|---|
| Example 1 | 473 | 9.0 | 26 |
| Example 2 | 465 | 16.8 | 36 |
| Example 3 | 454 | 6.3 | 21 |
| Example 4 | 471 | 23.5 | 59 |
| Comparative Example 1 | 457 | 6.5 | 4 |

From the comparison of the data of Example 1 and Example 2 with the data of Comparative Example 1 as shown in Table 2, the organic EL device including, as a light emitting dopant, the TADF material represented by the general formula (1), in which a boron-containing electron acceptor backbone is linked with an electron donor backbone having a specific fused ring structure, showed excellent results in both efficiency and lifetime as can be seen from the comparison with Comparative Example 1. It is considered that the reason for this is as follows: the use of an electron donor backbone having a specific fused ring structure reduced ΔEST and facilitated the development of TADF characteristics to thereby improve the efficiency; and in addition, the use of an electron donor backbone having a specific fused ring structure improved the stability against oxidation and the lifetime characteristics.

In particular, as clear from the data of Example 4, excellent results were obtained in terms of both the efficiency and the lifetime by using the compound represented by the general formula (1) as the TADF material and further using the fluorescence material as a light emitting dopant.

Reference Signs List

1 substrate, 2 the anode, 3 hole injection layer, 4 hole transport layer, 5 light emitting layer, 6 electron transport layer, 7 cathode.

## Claims

**1.** A thermally activated delayed fluorescence material represented by the following general formula (1):

[Formula 1]

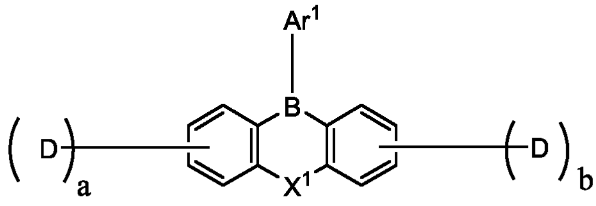

(1)

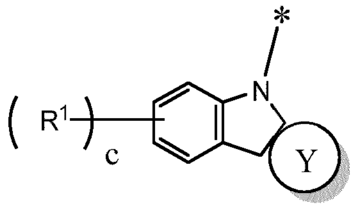

(1a)

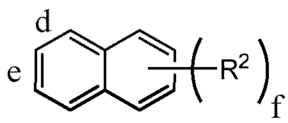

(1a-1)

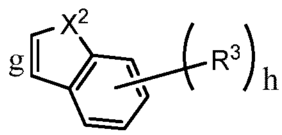

(1a-2)

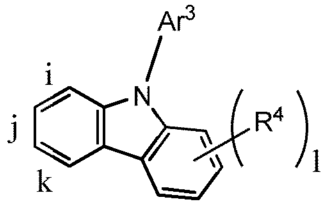

(1a-3)

wherein $X^1$ represents O or S; D is independently a nitrogen-containing heterocycle represented by formula (1a), * in the formula (1a) represents a bonding site to a ring in the general formula (1), and a ring Y is any of formulas (1a-1), (1a-2), and (1a-3); when the ring Y is the formula (1a-1), the ring Y is fused at either position d or e; when the ring Y is the formula (1a-2), the ring Y is fused at a position g, and $X^2$ represents O, S, or N-$Ar^2$; when the ring Y is the formula (1a-3), the ring Y is fused at any of positions i, j, and k; $Ar^1$ to $Ar^3$ each represent a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group formed by linking 2 to 5 aromatic rings thereof; $R^1$ to $R^4$ each represent deuterium, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms; and a and b each represent the number of substitutions and integer of 0 or 1, provided that a case where a and b are both 0 is excluded; and c, f, h, and 1 each represent the number of substitutions and an integer of 0 to 4.

**2.** The thermally activated delayed fluorescence material according to claim 1, wherein the ring Y is represented by the formula (1a-2) or (1a-3).

**3.** The thermally activated delayed fluorescence material according to claim 1 or 2, wherein the ring Y is represented by the formula (1a-3).

**4.** The thermally activated delayed fluorescence material according to any of claims 1 to 3, wherein $X^1$ is S.

**5.** The thermally activated delayed fluorescence material according to any of claims 1 to 4, having a difference between singlet excited energy (S1) and triplet excited energy (T1) of less than 0.20 eV.

**6.** The thermally activated delayed fluorescence material according to any of claims 1 to 4, having a difference between

singlet excited energy (S1) and triplet excited energy (T1) of less than 0.10 eV.

**7.** An organic electroluminescent device comprising one or more light emitting layers between an anode and a cathode opposite to each other, wherein at least one of the light emitting layers contains the thermally activated delayed fluorescence material according to any of claims 1 to 6.

**8.** The organic electroluminescent device according to claim 7, wherein the light emitting layer containing the thermally activated delayed fluorescence material contains a host material.

**9.** The organic electroluminescent device according to either claim 7 or 8, the light emitting layer containing the thermally activated delayed fluorescence material further contains a light emitting dopant other than the thermally activated delayed fluorescence material represented by the general formula (1).

[ Fig. 1 ]

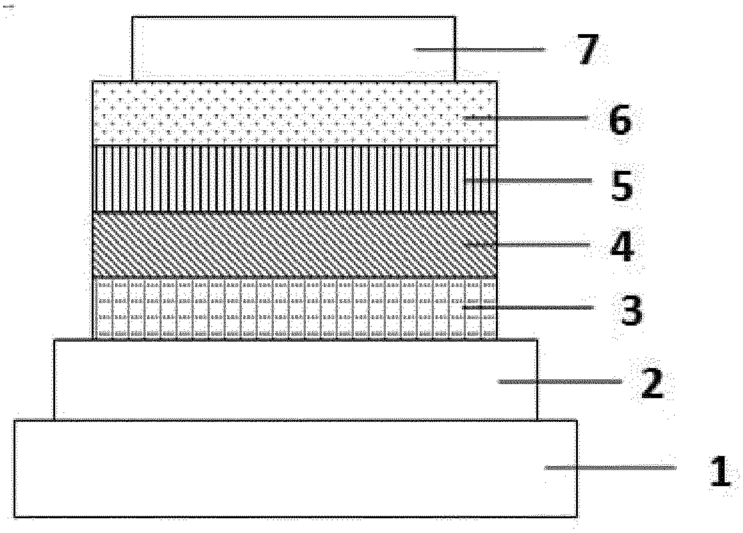

**INTERNATIONAL SEARCH REPORT**

International application No.
**PCT/JP2021/025469**

**A. CLASSIFICATION OF SUBJECT MATTER**

***C09K 11/06***(2006.01)i; ***H01L 51/50***(2006.01)i
FI: C09K11/06 660; H05B33/14 B

According to International Patent Classification (IPC) or to both national classification and IPC

**B. FIELDS SEARCHED**

Minimum documentation searched (classification system followed by classification symbols)

C09K11/06; H01L51/50

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

CAplus/REGISTRY (STN)JSTPlus/JMEDPlus/JST7580 (JDreamIII)

**C. DOCUMENTS CONSIDERED TO BE RELEVANT**

| Category* | Citation of document, with indication, where appropriate, of the relevant passages | Relevant to claim No. |
|---|---|---|
| X | AHN, D. H. et al. Highly Twisted Donor-Acceptor Boron Emitter and High Triplet Host Material for Highly Efficient Blue Thermally Activated Delayed Fluorescent Device. ACS Applied Materials & Interfaces, (2019), vol. 11, no. 16, pp. 14909-14916, DOI 10.1021/acsami.9b00931<br>in particular, abstract, fig. 1, p. 14911, right column, tables 1, 2, etc. | 1-3, 5, 7-8 |
| A | entire document | 4, 6, 9 |
| A | US 2018/0366653 A1 (GUANGZHOU CHINARAY OPTOELECTRONIC MATERIALS LTD.) 20 December 2018 (2018-12-20)<br>claims, paragraphs [0053]-[0062], examples, etc. | 1-9 |
| A | CN 110698504 A (TIANMA MICRO-ELECTRONICS CO., LTD.) 17 January 2020 (2020-01-17)<br>claims, examples | 1-9 |

☐ Further documents are listed in the continuation of Box C.  ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **09 September 2021** | **28 September 2021** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2021/025469**

| Patent document cited in search report | Publication date (day/month/year) | Patent family member(s) | Publication date (day/month/year) |
|---|---|---|---|
| US 2018/0366653 A1 | 20 December 2018 | WO 2017/092508 A1<br>CN 108137618 A | |
| CN 110698504 A | 17 January 2020 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2010134350 A
- WO 2011070963 A
- WO 2014050904 A
- WO 2015072537 A